Europäisches Patentamt

European Patent Office

Office européen des brevets

(11) Numéro de publication: **0 054 596**
**B1**

(12) **FASCICULE DE BREVET EUROPEEN**

(45) Date de publication du fascicule du brevet: **29.05.85**

(51) Int. Cl.⁴: **G 01 B 11/00, G 03 B 41/00**

(21) Numéro de dépôt: **80430030.9**

(22) Date de dépôt: **18.12.80**

(54) Procédé d'inspection et de tri automatique d'objets présentant des configurations avec des tolérances dimensionnelles et des critères de rejet variables selon l'emplacement, équipement et circuits de mise en oeuvre.

(43) Date de publication de la demande:
**30.06.82 Bulletin 82/26**

(45) Mention de la délivrance du brevet:
**29.05.85 Bulletin 85/22**

(84) Etats contractants désignés:
**DE FR GB IT**

(56) Documents cités:
**WO-A-79/00876**
**FR-A-2 439 437**

(73) Titulaire: **International Business Machines Corporation**
**Old Orchard Road**
**Armonk, N.Y. 10504 (US)**
(84) **DE GB IT**

(73) Titulaire: **Compagnie IBM FRANCE**
**5 Place Vendôme**
**F-75000 Paris 1er (FR)**
(84) **FR**

(72) Inventeur: **Linger, Claude Jacques André**
**13, rue des Haies**
**F-75020 Paris (FR)**
Inventeur: **Locicero, Gisèle Christiane Martine**
**1 bis chemin des Vieilles Portes**
**F-91000 Evry (FR)**

(74) Mandataire: **Klein, Daniel Jacques Henri**
**Compagnie IBM France Département de Propriété Industrielle**
**F-06610 La Gaude (FR)**

Courier Press, Leamington Spa, England.

EP 0 054 596 B1

# 0 054 596

**Description**

Domaine Technique

La présente invention concerne d'une part un procédé d'inspection sans contact et de tri automatique d'objets présentant des tolérances dimensionnelles et des critères de rejet variables selon l'endroit inspecté de l'objet, et d'autre part son équipement et les circuits de mise en oeuvre. Elle concerne plus particulièrement un procédé d'inspection sans contact et de tri automatique d'objets présentant des configurations ayant des tolérances dimensionnelles et des critères de rejet variables selon l'endroit inspecté, tels que les circuits imprimés, les masques, les modules et les microplaquettes de circuits intégrés, employés dans l'industrie des semiconducteurs, qui utilise les transformations de base de la morphologie mathématique et de la théorie des ensembles. Elle concerne également sont équipement et les circuits de mise en oeuvre réalisés autour d'un ordinateur numérique.

Etat de la technique antérieure

De nombreux procédés basés sur le principe de la comparaison entre un objet de référence, conforme aux spécifications et un objet similaire à examiner, dont la conformité doit être vérifiée, existent à ce jour. On pourra en particulier se référer aux documents suivants:

Le brevet FR—A 2.249.520 décrit un procédé consistant: à balayer l'objet de référence avec un détecteur d'infrarouge, à balayer l'objet à examiner à l'aide d'un détecteur d'infrarouge, à comparer les signaux engendrés par l'objet de référence et par l'objet examiné pour déceler toute différence entre ces signaux, et à analyser statistiquement toute différence pour déterminer si l'objet subissant l'examen est opérationnel dans des limites prescrites. Cet appareil ne se rapporte pas au contrôle de configurations géométriques à tolérances variables.

Le brevet ci-dessus est caractéristique de la technique de comparaison selon un paramètre électrique déterminé (ici le passage du courant), entre un objet de référence et un objet similaire à examiner. S'agissant de comparer selon le même principe, des configurations de dessins, le brevet français FR—A 2 095 523 montre un appareil de détection de défauts par balayage optique. Cet appareil trouve essentiellement application dans le domaine de la fabrication de photo-masques. Cet appareil qui est applicable au contrôle d'objets présentant des configurations avec des tolérances variables selon l'emplacement ne peut fonctionner que si l'objet à examiner présente des configurations répétitives; en outre l'objet de référence, est un objet spécial, qui n'appartient pas à la famille des objets à examiner, et qui est donc construit spécialement pour tenir compte de certaines spécificités de l'objet à examiner.

En ce qui concerne le tri d'objets présentant des configurations avec des tolérances dimensionnelles variables, la technique pratiquée aujourd'hui consiste dans le tri-optique manuel effectué par des opérateurs à l'aide de binoculaires. Cette opération est longue, pénible et coûteuse. Pratiquement le tri n'est effectué que sur quelques échantillons pris au hasard sur les lignes de fabrication. On ne peut donc exclure des problèmes de qualité et de fiabilité lorsque les objets seront en service en clientèle.

Exposé de l'invention

Un premier but de l'invention est de proposer un procédé et un équipement qui permettent d'automatiser l'inspection et le tri d'objets présentant des configurations avec des tolérances dimensionnelles et des critères de rejet variables et, qui évitent de recourir au tri optique manuel.

Un autre but de la présente invention est de proposer un procédé et un équipement d'inspection et de tri d'objets présentant des configurations avec des tolérances et des critères de rejet variables selon l'emplacement desdites configurations.

Un autre but de l'invention est de proposer un procédé et un équipement de détection de défauts, d'un objet à examiner, à partir d'un objet de référence de la même famille.

Un autre but de l'invention est de proposer un procédé et un équipement qui permettent l'inspection et le tri d'objets présentant des configurations avec des tolérances et des critères de rejet variables selon l'emplacement permettant de déterminer si l'objet à examiner est opérationnel dans des limites prescrites, à partir de critères de rejet préalablement déterminés.

Un autre but de l'invention est de proposer un procédé et un équipement qui permettent l'inspection et le tri d'objets présentant des configurations avec des tolérances et des critères de rejet variables selon l'emplacement selon lesquels lesdits critères de rejet seront élaborés automatiquement à partir d'un objet de référence lors d'une étape préliminaire du procédé.

Encore un autre but de l'invention est de proposer un procédé et un équipement d'inspection et de tri d'objets présentant des configurations avec des tolérances et des critères de rejet variables selon l'emplacement selon lesquels la capacité nécessaire de la mémoire pour réaliser les fonctions d'ajustement aux tolérances variables et d'analyse selon des critères de rejet variables, est très faible devant le nombre de bits représentatifs de l'image (par exemple 20 lignes mémoire de 2048 bits pour une image qui peut comporter 2048 (ou plus) lignes de 2048 bits).

La présente invention a donc pour objet d'une part, un procédé d'inspection et de tri automatique d'objets tel que défini dans la revendication 1 et d'autre part, un appareil pour l'inspection et le tri automatique d'objets, lequel appareil a les caractéristiques indiquées dans la revendication 17.

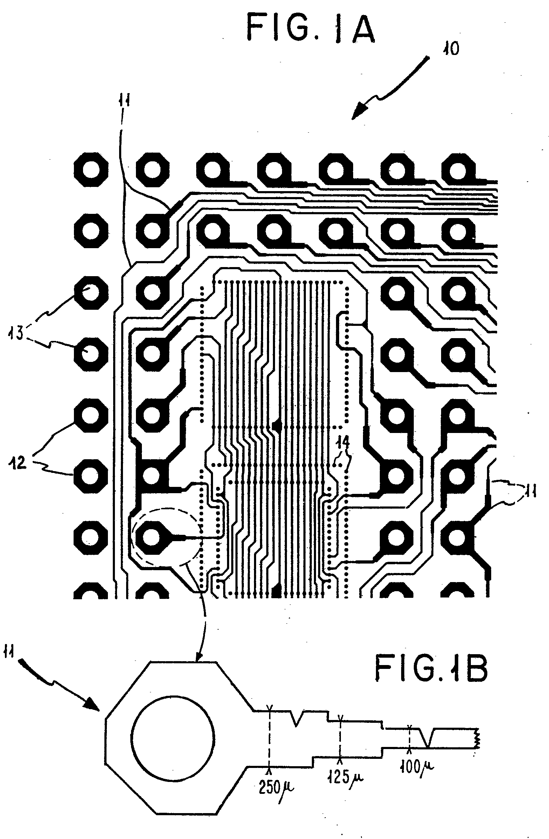

Dans la présente demande, pour la simplification de l'exposé, seule l'application au tri de modules

2

**0 054 596**

céramiques (du genre de celui représenté sur la figure 1A) sera détaillée. L'adaptation du procédé de la présente invention à d'autres objets présentant des tolérances variables couramment utilisés dans l'industrie des semi-conducteurs, tels que: masques, réticules, cartes de circuits imprimés, microplaquettes de circuits intégrés etc., est sans difficulté majeure pour l'homme de l'art. La présente invention s'attache essentiellement aux configurations géométriques des objets et n'est donc pas limitée à ce seul domaine d'application.

Un module électronique 10, dont une portion est représentée sur la figure 1A constitue un bon exemple de cette catégorie d'objets. En effet, les conducteurs métalliques 11 formés sur le substrat céramique ont des largeurs et des directions différentes. Pratiquement les conducteurs peuvent avoir trois largeurs: 250, 125 et 100 µ et suivent quatre directions: 0, 45, 90 et 135°. Les pattes de métallisation 12 qui entourent les broches 13 ont une forme octogonale ou en dérivant. Les conducteurs relient généralement une patte 12 à un plot de contact 14 qui reçoit une bille de soudure de la microplaquette (non représentée). Les instructions de contrôle précisent les dimensions minimales des conducteurs, par un certain pourcentage de leur largeur nominale. Ce pourcentage est généralement le même pour tous les conducteurs. Les dimensions maximales quant à elles dépendant de l'espace interconducteur à respecter sur le substrat. Il est donc évident qu'avec ce type de module les tolérances dimensionnelles minimales et maximales (en valeur absolue) dépendent de la configuration des conducteurs dans la region analysée. Etant donnée qu'il est prévu dans la présente invention une étape d'adjustement de l'image de référence aux tolérances dimensionnelles, il est clair que cet ajustement devra tenir compte de la région analysée.

Par ailleurs, un même défaut peut être acceptable ou non selon son emplacement, par exemple un même défaut de manque est sans importance dans le conducteur de largeur 250 µ, alors qu'il est catastrophique pour le conducteur de largeur 100 µ (voir figure 1B) et qu'il conduit alors au rejet du module. On comprendra alors que le critère de rejet devra lui aussi tenir compte de la région analysée. Chaque fois qu'un défaut sera détecté, il faudra lui associer le (ou les) critères de rejet établi(s) pour cette région.

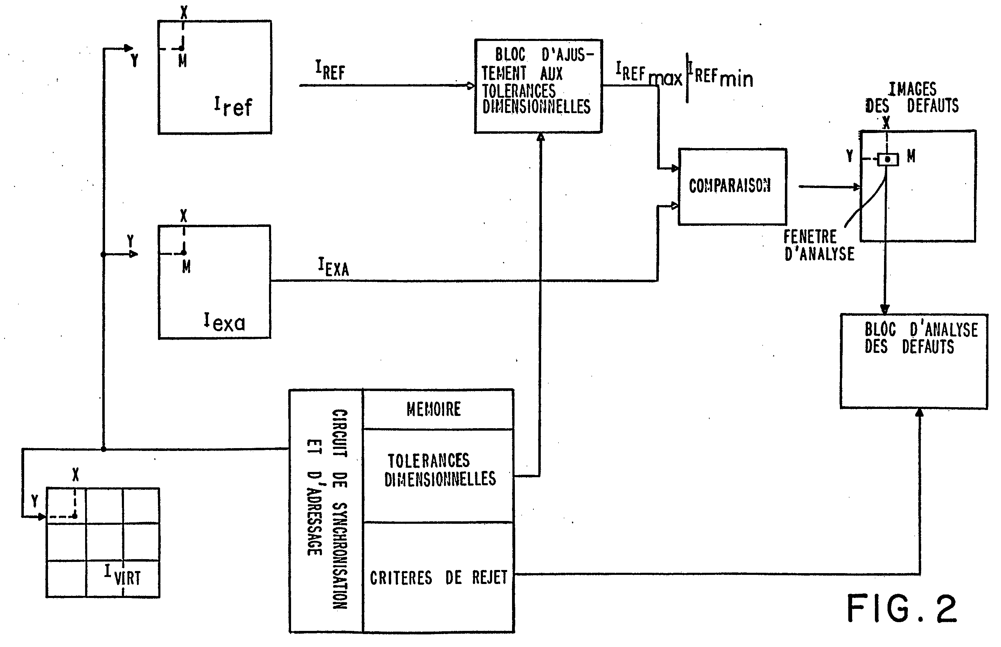

Ces deux impératifs sont essentiels pour la compréhension du procédé de la présente invention, dont le principe est représenté schématiquement sur la figure 2.

Les images du module de référence ($I_{ref}$) et du module échantillon ($I_{exa}$), sont saisies, échantillonnées et quantifiées, puis seuillées, nettoyées et cadrées pour fournir des images binaires ou électroniques, respectivement $I_{REF}$ et $I_{EXA}$. L'image du module de référence est ajustée aux tolérances dimensionnelles maximales et minimales par deux voies différentes. On obtient $(I_{REF})_{max}$ et $(I_{REF})_{min}$. Ces images sont comparées à l'image du module échantillon $I_{EXA}$ pour donner une image des défauts du genre "manque" et une image des défauts du genre "extension". Les images de défaut sont scrutées par une fenêtre d'analyse pour détermine s'ils sont acceptables ou non.

Un mode de réalisation de la présente invention se caractérisée par la présence d'un circuit de synchronisation et d'adressage associé à une mémoire, qui pour chaque point M de coordonnées X, Y analysé assure une double fonction. Il détermine d'abord la valeur de la tolérance dimensionnelle pour ce point et agit sur le bloc d'ajustement aux tolérances dimensionnelles. En d'autres termes, la modulation de $I_{REF}$ aux tolérances dimensionnelles, effectués avant l'opération de comparaison, est variable selon l'emplacement. En outre, ce circuit, agit après l'opération de comparaison sur l'image des défauts en tenant compte des délais, il détermine les critères de rejet (pratiquement une taille maximale acceptable du défaut) pour ce point et les fournit à un bloc d'analyse des défauts constitué essentiellement par des circuits de calcul et de comparaison. Ces circuits calculent les projections du défaut selon deux directions: la direction θ du conducteur qui contient ce point du défaut, et sa direction perpendiculaire. Ensuite, ils comparent ces projections avec les critères de rejet, et déterminent finalement si le défaut a une taille acceptable ou non. La mémoire a été préalablement chargée, manuellement ou automatiquement, des différentes données concernant les tolérances dimensionnelles et les critères de rejet pour chaque point à analyser. Ces données, lorsqu'elles sont établies pour chaque point de $I_{REF}$ peuvent nécessiter une place trop considérable en mémoire, aussi dans la présente demande on prévoit de travailler par région. On définit une image virtuelle $I_{VIRT}$ correspondante à $I_{REF}$ découpée en carriés, et pour tous les points M d'un carré, les données seront identiques: Le résultat de l'analyse des défauts, commande la décision bon/rejet du module échantillon examiné.

Les buts, caractéristiques et avantages de la présente invention ressortiront mieux de l'exposé qui suit, fait en référence aux dessins annexés à ce texte, qui représentent un mode de réalisation préféré de celle-ci.

Brève description des figures

La figure 1A représente une portion d'un module électronique caractéristique, qui présente des configurations de conducteurs avec des tolérances variables selon l'emplacement.

La figure 1B représente un conducteur après agrandissement.

La figure 2 représente le diagramme de principe qui met en évidence les principales caractéristiques de la présente invention.

La figure 3 représente l'organigramme des différentes étapes du procédé d'inspection et de tri de la présente invention.

La figure 4 représente les histogrammes de la distribution des points "image" (pixels) selon l'amplitude du signal pour deux images l'une très contrastée et l'autre dont le fond présente un gradient de gris, en noir et blanc avec seize niveaux de gris.

3

**0 054 596**

La figure 5 représente l'évolution d'une image échantillonnée selon une trame héxagonale après une transformation morphologique du type érosion.

La figure 6 représente respectivement deux motifs (marqueurs) de l'image de l'objet de référence et l'image de l'objet à examiner qui doivent être cadrées.

La figure 7 représente la courbe I(Mx) qui représente la surface hachurée montrée sur la figure 6 et qui est proportionnelle au décalage Mx des motifs et sa variation en fonction du déplacement de l'objet à examiner.

La figure 8 représente de façon similaire la courbe I(My).

La figure 9 représente différents défauts du genre "extension".

La figure 10 représente différents défauts du genre "manque".

La figure 11A représente une portion agrandie d'un conducteur du module montré à la figure 1A avec des défauts du genre "manque", qui permet de comprendre la détermination des critères de rejet pour ces défauts.

La figure 11B représente une portion agrandie d'un espace interconducteur du module montré à la figure 1A avec des défauts du genre "extension" qui permet de comprendre la détermination des critères de rejet pour ces défauts.

La figure 12 représente une portion agrandie du module montré sur la figure 1A qui comprend deux conducteurs formés dont on calcule les longueurs de traversée selon quatre directions 0, 45, 90 et 135°C.

La figure 13 représente le principe du balayage de l'image du module selon les quatre directions pour la génération automatique des tables de données qui commandent l'ajustement aux tolérances dimensionnelles et les critères de rejet.

La figure 14 représente schématiquement le bloc diagramme de l'équipement mettant en évidence les différents éléments qui le compose.

La figure 15 représente le schéma synoptique de l'unité de traitement mettant en évidence les différents blocs qui le composent.

La figure 16 représente un élément structurant fonctionnant comme un diaphragme photographique en forme de cercle, pour l'ajustement aux tolérances dimensionnelles variables.

La figure 17 représente le détail du bloc d'ajustement aux tolérances dimensionnelles minimales (érosion) de la figure 15.

La figure 18 représente le détail du bloc d'ajustement aux tolérances dimensionnelles maximales (dilatation) de la figure 15.

La figure 19 représente le détail du bloc de comparaison de la figure 15.

La figure 20 représente une fenêtre d'analyse carrée de 15 pixels×15 pixels, présentant quatre directions de symétrie.

La figure 21 représente un conducteur présentant un défaut caractéristique du genre "manque".

La figure 22 représente schématiquement le bloc d'analyse de défaus qui effectue d'une part le calcul des projections du défaut selon deux directions (la direction du conducteur qui le contient, et la direction perpendiculaire) et, d'autre part la comparaison de ces projections avec les critères de rejet pour cet emplacement de défaut, afin de fournir les éléments de décision: bon/rejet.

La figure 23 représente le détail du circuit de calcul de la projection du défaut selon une direction ($\theta=0$), et

La figure 24 représente le circuit de comparaison de cette projection du défaut avec les critères de rejet.

Description de l'invention

Dans le présent procédé on fera appel aux opérations booléennes bien connues telles que l'union, l'intersection et l'inversion pour traiter les images électroniques et mettre en évidence les défauts. Cependant, d'autres opérations seront nécessaires pour nettoyer les images ou les modifier en tenant compte des tolérances dimensionnelles minimales et maximales des circuits, ces opérations qui relèvent de la morphologie mathématique-essentiellement l'érosion et la dilatation-font l'objet ci-après d'un bref rappel.

I. Elements de morphologie mathematique

Les définitions des différentes transformations de base utilisées dans le traitement numérique de l'image conformément aux enseignements de la présente invention reposent principalement sur les notions d'élément structurant et de transformations par "tout ou rien": érosion ou dilatation. L'espace sur lequel on travaille est l'espace euclidien R2 muni de sa métrique d. 0 désigne l'origine de l'espace considéré. Si B désigne un ensemble quelconque de cet espace, $B_x$ désigne le translaté de B par le vecteur $\overrightarrow{Ox}$. On définit

a) la dilatation

Soient A et B deux ensembles de R2, on appelle dilaté de A par B un nouvel ensemble noté A⊕B tel que:

$$A \oplus B = \{ x \varepsilon \overline{R2} \mid B_x \cap A \neq \phi \}$$

en d'autres termes un point x de l'espace R2 appartient au dilaté de A par B si et seulement si le translaté de B par $\overrightarrow{Ox}$ rencontre A. L'ensemble B est appelé l'élément structurant.

4

b) l'érosion

Soient A et B deux ensembles de R2. On appelle érodé de A par B l'ensemble noté A⊖B tel que

$$A\ominus B=\{x\varepsilon R2 \mid B_x\subset A\}$$

un point x de l'espace R2 appartient à l'érodé de A par B si et seulement si l'ensemble $B_x$ est totalement inclus dans A.

c) dilatation et érosion circulaires

C'est l'hypothèse où l'élément structurant est un cercle.
On note

$$D(x,p)=\{y\varepsilon R2 \mid d(x,y)\leq\rho\}$$

le disque de centre x et de rayon ρ. En d'autres termes un point y de l'espace R2 appartient au disque si la distance qui sépare ce point du centre est inférieure ou égale au rayon.

La distance entre un point x et un ensemble X de R2 est définie par

$$d(x,X)=\inf d(x,y) \text{ avec } y\varepsilon X$$

le disque de centre 0 et de rayon ρ, soit D(0,ρ) se note ρD.

Le dilaté d'un ensemble X par l'ensemble ρD est tel que

$$X\oplus\rho D=\{x\varepsilon R2 \mid d(x,X)\leq\rho\}$$

de même l'érodé peut être défini tel que

$$X\ominus\rho D=\{x\varepsilon R2 \mid D(x,\rho)\subset X\}$$

d) propriétés

On peut établir que le dilaté a A par B est identique à l'ensemble complémentaire de l'érodé du complément de A par B soit

$$A\oplus B=(A^c\ominus B)^c$$

Toutes ces transformations par tout ou rien sont itératives. On peut alors définir deux autres opérations.

L'ouverture: c'est l'érosion suivie d'une dilatation soit (A⊖B)⊕B et
La fermeture: c'est la dilatation suivie d'une érosion soit (A⊕B)⊖B
Ces deux dernières transformations seront utilisées pour le nettoyage des images.

D'une manière générale, l'érosion supprime de l'image les parties isolées plus petites que l'élément structurant (il en est donc de même pour la dilatation sur $A^c$).

L'ouverture supprime de A toutes les parties plus petites que l'élément structurant sans changer le restant de l'image (la fermeture a un effet identique sur $A^c$).

II. Procede de traitement numerique de l'image:
Description des differentes etapes de traitement

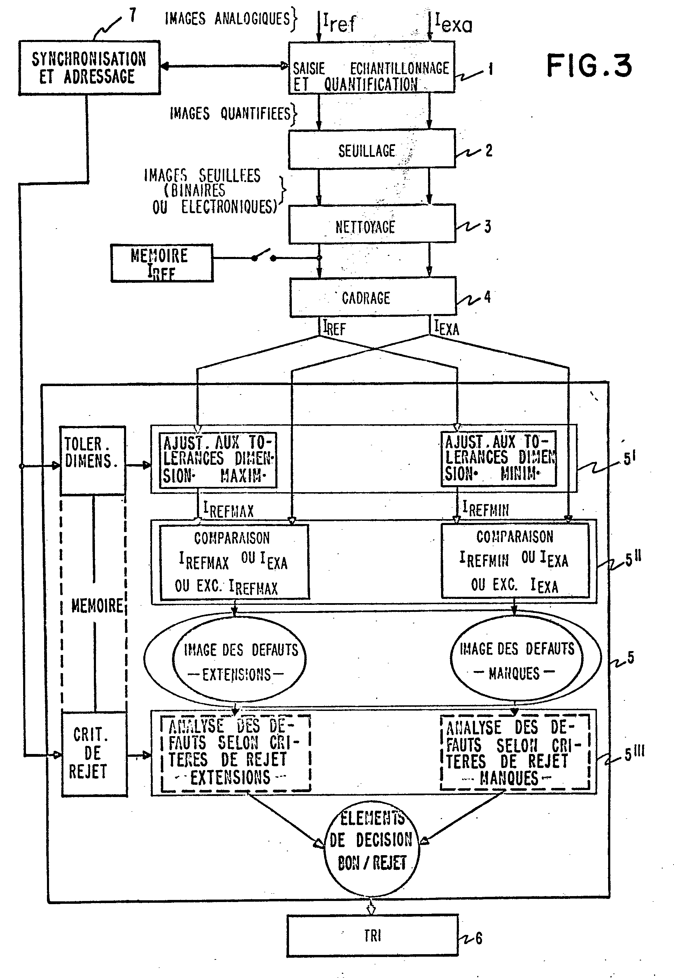

Les différentes étapes de base sont représentées sur l'organigramme de la figure 3 et portent les références 1 à 6.

1. Saisie de l'image, échantillonnage et quantification

Les images du module de référence ($I_{ref}$) et du module à examiner ($I_{exa}$) fournies par le capteur sont par exemple en noir et blanc avec tous les niveaux de gris. Ces images analogiques sont d'abord échantillonnées, selon une trame héxagonale ou carrée, par exemple. L'amplitude du signal est quantifiée en chaque point de l'image, et cette information est codée sur 4 bits. Les images peuvent comporter un nombre de lignes et de bits par ligne variable selon les applications. En général 1024 ou 2048 lignes constituent des nombres satisfaisants pour la majorité des applications. Dans la présente application on choisit 2048 lignes de 2048 bits chacune, soit avec un module de 2,54×2,54 cm un pas de 12,5 µ entre deux points images (pixels). Il en resulte environ 4 millions de points à traiter.

2. Le seuillage

Pour le traitement automatique des défauts, seule compte la géométrie des motifs du module. C'est pour cela que l'on traite des images binarisées, obtenues après seuillage.

Tout point de l'image présentant un niveau de gris supérieur à un certain seuil sera égalé à 1, sinon à 0. Cette étape permet d'obtenir des images binaires en noir et blanc. Le problème sera de détecter le bon seuil, pour les modules que l'on veut analyser.

**0 054 596**

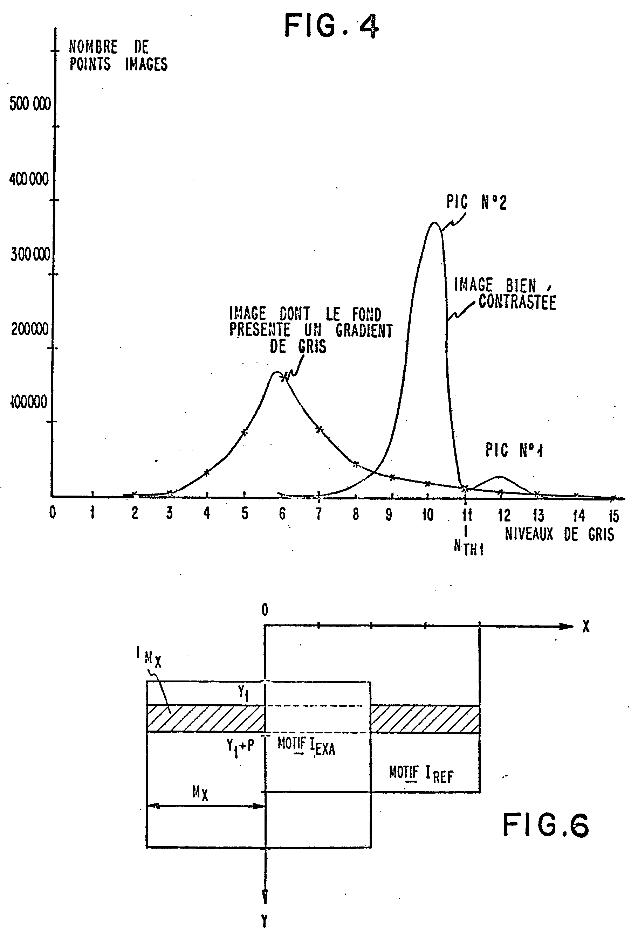

Une technique de seuillage appropriée basée sur l'établissement de l'histogramme des images est décrite ci-aprés à l'aide de la figure 4. Pour des images discrétisées (16 niveaux de gris) et bien contrastées, les histogrammes présentent deux pics ou modes bien différentiés qui sont représentés sur une des courbes de la figure 4. Le pic No. 1 représente la distribution des motifs du module tandis que le pic No. 2 représente la distribution du fond de l'image. Pour détecter le bon seuil il suffit de choisir la valeur $N_{TH}$ du seuil correspondant à la vallée entre les deux pics. En ce qui concerne l'exemple de la courbe correspondant à une image bien contrastée, on trouve $N_{TH}=11$. Ainsi, tous les points de l'image analysée présentent un niveau de gris supérieur à 11, se verront attribuer la valeur binaire 1, tous les autres points se verront attribuer la valeur binaire 0.

Quand l'image présente un gradient de gris pour le fond, la vallée qui sépare les deux pics devient moins sensible et il devient alors difficile de choisir le seuil optimal. Pour ce type d'image, le choix du seuil peut se faire de différentes façons, notamment en traitant les images par région. On détecte le seuil de chaque région à partir de son histogramme. L'image seuillée résultante est alors la composition de toutes les régions seuillées. Un exemple d'histogramme caractéristique d'une image de ce type est donné par l'autre courbe de la figure 4. Dans ce cas l'expérience montre que la valeur du seuil $N_{TH}$ peut être choisie égale à 7. Dans un grand nombre de cas on peut faire automatiquement par programme une détection automatique du seuil par l'analyse de l'histogramme des intensités des points images de l'image analysée.

Différentes techniques y compris celles mentionnées ci-dessus, pourront être trouvées dans la publication suivante:

A Survey of Edge Detection Techniques, par Larry Davis, publié dans Computer Graphics and Image Processing (1975), 4, pages 248—270 et plus particulièrement dans la référence à l'article de C. K. Chow.

3. Le nettoyage

Le nettoyage s'effectue par une érosion qui supprime tous les points images relatifs au bruit. La taille de l'élément structurant qui va éroder l'image doit être inférieure à la taille du plus petit défaut que l'on doit détecter. Les parties isolées plus petites que la taille d'érosion disparaissent tandis que les autres restent et sont seront ultérieurement reconstituées par une dilatation de même taille (globalement l'opération constitue une ouverture). Selon la nature des points relatifs au bruit que l'on désire supprimer dans l'image on lui fait subir soit une ouverture, soit une fermeture soit encore les deux opérations successivement. L'opération de dilatation, s'effectue de façon symétrique: on érode l'image complémentaire de la trame et on prend le complément du résultat, selon la relation explicitée ci-dessous:

$$A \oplus B = (A^c \ominus B)^c$$

Le nettoyage peut être également opéré après l'étape de cadrage. Enfin, cette étape peut être facultative selon la qualité des images.

Pratiquement pour ces opérations de la morphologie mathématique: érosion, dilatation, on a le choix entre différents éléments structurants, notamment selon la trame utilisée. Sur l'image quantifiée et seuillée (image dite binaire ou électronique) qui a été échantillonnée suivant la trame héxagonale on peut choisir l'héxagone, qui est l'élément structurant le plus proche du cercle. Un héxagone de taille n, où le produit du pas d'échantillonnage par n, représentera le rayon du cercle. Dans ce cas, pour l'opération d'érosion de taille 1 par exemple, tous les points de l'image sont scrutés par l'élément structurant qui sera un héxagone de taille 1 (le plus petit hexagone de la maille d'échantillonnage). Tous les sommets de l'héxagone ainsi que son centre sont égalés à 1. On centre l'héxagone sur le point à analyser. Si le voisinage héxagonal de chaque point ainsi que le point lui-même coïncide avec les valeurs données à tous les sommets de l'héxagone (centre compris), alors le point initial prend la valeur binaire 1, dans le cas contraire il prend la valeur binaire 0. En d'autres termes on supprime donc de l'image tout point binaire égal à 1 qui a au moins un voisin égal à 0, tandis que les points binaires égaux à 0 gardent leur valeur: l'image a donc subi une transformation par tout ou rien.

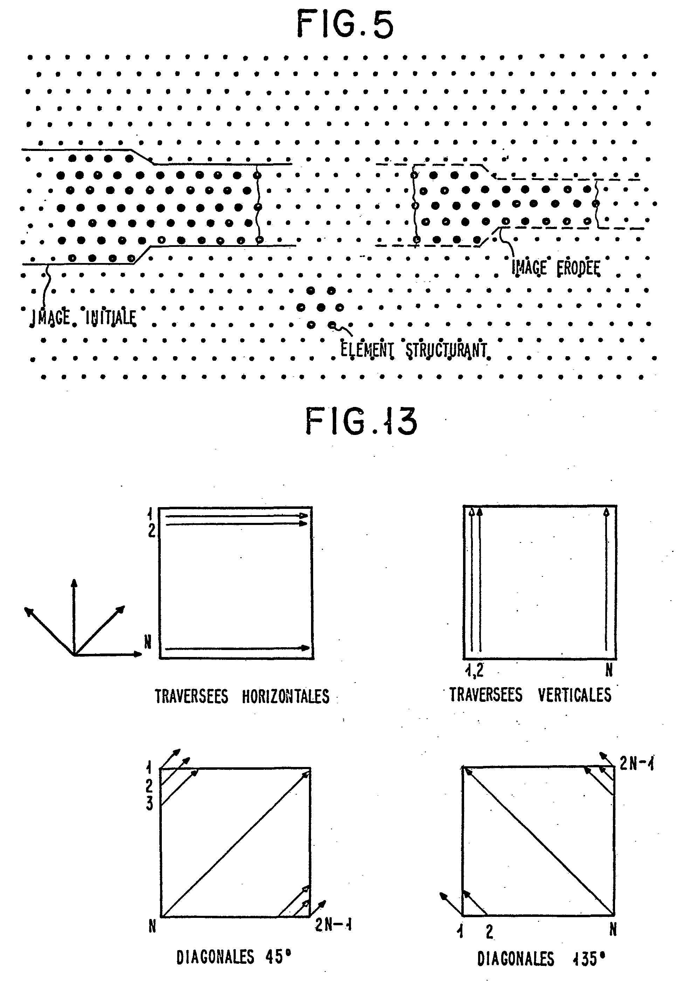

Un exemple d'une opération d'érosion apparaît clairement sur la figure 5, on a choisi comme image initiale une portion de conducteur.

En ce qui concerne l'opération de dilatation, on peut soit opérer directement à partir de l'image initiale, soit se souvenir que l'on peut éroder le complément de l'image initiale, puis complémenter le résultat.

Si une trame carrée est utilisée on pourra utiliser un élément structurant en forme de croix ou de cercle (approximativement). La taille et le motif de l'élément structurant peuvent varier selon le type d'application. Dans la présente description, la trame carrée et un élément structurant en forme de cercle et de taille variable, seront seuls utilisés aux fins de la simplicité de l'exposé.

Le nombre de points images (pixels) peut varier de 500 000 à 10 millions et plus selon les applications.

4. Le cadrage

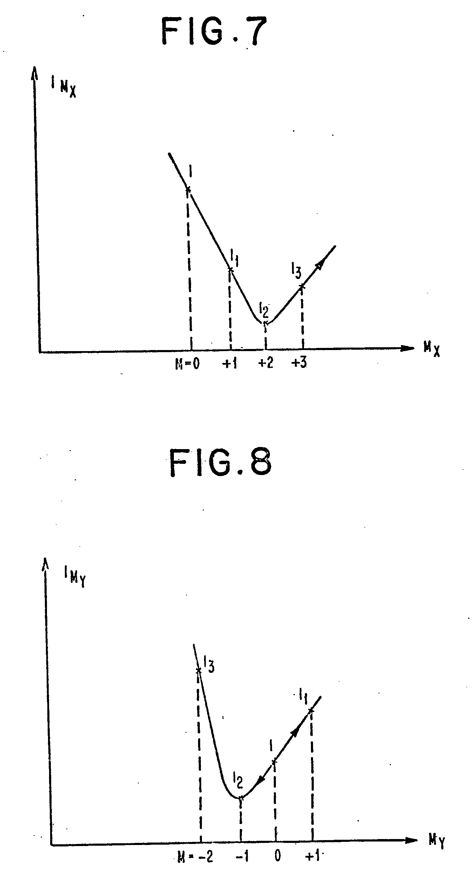

Avant de comparer l'image de référence avec l'image échantillon, il est nécessaire de recadrer les deux images dans l'espace. Cette opération qui doit être automatique peut se faire par programme. Différentes techniques connues de l'homme de l'art, notamment pour le cadrage ou l'alignement des masques (par exemple à l'aide de marqueurs ou repères) peuvent être utilisées. Une technique de recadrage donnant satisfaction est explicitée ci-après à l'aide de la figure 6.

6

# 0 054 596

Sur la figure 6 on a représenté schématiquement deux motifs, l'un appartenant à l'image du module de référence $I_{ref}$ et l'autre à l'image du module échantillon, $I_{exa}$, ce dernier motif est désaligné par rapport à celui de l'image de référence. Ces motifs peuvent être des portions de marqueurs ou repères qui sont couramment utilisés pour l'alignement des masques, des modules, etc.

Un programme permet de calculer le décalage entre les deux images, en x et en y.

Pour calculer ce décalage en x, qui est représenté par $M_x$, il suffit de prendre quelques lignes y successives (à partir d'une ligne déterminée $y_1$) qui traversent les deux images et de calculer la surface hachurée $I(M_x)$. On s'aperçoit sur la figure 6 que plus on décale $I_{exa}$ vers la droite (par incrément sur l'axe des x), plus cette surface $I(M_x)$ diminue. Elle tend vers un minimum quand on atteint le recadrage optimal en x.

Pour que le calcul soit plus rapide, le programme ne traite qu'un groupe limité p de lignes pour le décalage en x, et de q colonnes pour le décalage en y.

Le choix des paramètres ($y_1$ et p, en ce qui concerne le décalage en x), se fait à l'entrée du programme. Ce programme consiste donc à analyser la fonction $I(M_x)$ qui représente la surface hachurée, selon les différentes valeurs des $M_x$ (décalage en x entre les deux images).

Il détermine alors automatiquement la valeur $M_x$, à un minimum de la fonction $I(M_x)$.

On opère de la même façon pour le décalage en y en prenant des lignes verticles parallèles à l'axe Oy, ce qui conduit à la détermination de $I(M_y)$ et $M_y$ à l'aide des paramètres correspondants ($x_1$, q).

En prenant comme exemple la configuration montrée sur la figure 6, le résultat de ces opérations logiques prend la forme des courbes montrés sur les figures 7 et 8. Sur ces figures on a représenté, $I(M_x)$ et $I(M_y)$ qui mettent en évidence les minima pour certaines valeurs de M. Sur la figure 7 on voit que la fonction $I(M_x)$ décroît à partir de la valeur initiale I en prenant les valeurs $I_1$, $I_2$, avant de croître et prendre la valeur $I_3$, pour différentes valeurs de $M_x$, quand on a décalé $I_{exa}$ par incréments successifs vers la droite. Le minimum de $I(M_x)$ est obtenu pour deux incréments. Il faut donc déplacer $I_{exa}$ de deux incréments vers la droite.

De façon similaire, $I(M_y)$ est représentée sur la figure 8. Cette figure montre qu'une première tentative ($I_1$) vers la droite est dans la mauvaise direction puisque $I_1 > I$, puis vers la gauche, le minimum est donc obtenu pour un incrément vers les y négatifs.

Cette étape de recadrage peut être aisément effectuée à l'aide d'un programme informatique.

En ne choisissant qu'une partie de l'image, il faut cependant s'assurer que ces lignes traversent bien les motifs du module analysé tant pour l'échantillon que pour la référence, et non pas le fond uniquement. Le choix se fait simplement à partir de l'image de référence que l'on connaît au départ et qui permet la détermination de ces paramètres ($x_1$, $y_1$, p, q, ...). De plus si l'on veut que les résultats du calcul du décalage ait une réalité physique il faut que le motif de $I_{ref}$ chevauche le motif correspondant de $I_{exa}$. Ceci peut être assuré par un cadrage grossier effectué lors de la saisie d'images. Après avoir successivement saisies, échantillonnées, quantifiées, seuillées, nettoyées et cadrées, les images binaires obtenues sont notées $I_{REF}$, pour l'image résultante du module de référence et $I_{EXA}$ pour l'image résultante du module à examiner.

Il faut comprendre que dans certaines applications le recadrage peut se faire soit dans le plan (x, y, θ) soit même dans l'espace (x, y, z).

## 5. Mise en évidence des défauts 5.1 Introduction: Cas des modules présentant des configurations avec des tolérances fixes.

Dans l'industrie des circuits intégrés à semi-conducteurs, on a vu que les objets à comparer sont essentiellement des masques (réticules), des microplaquettes de circuits intégrés, et des modules électroniques. Dans tous les cas il existe des tolérances dimensionnelles pour les motifs de ces objets par exemple en ce qui concerne les modules, la largeur des lignes conductrices.

Toutes les tolérances dimensionnelles sont connues et spécifiées dans des instructions de fabrication et de contrôle et varient naturellement selon la nature des objets à analyser. Certaines sont fixes sur tout l'objet à analyser d'autres sont variables selon l'emplacement des motifs sur l'objet (c'est le cas du module perfectionné représenté sur la figure 1A de la présente demande). Par ailleurs on a noté qu'il y avait deux grands genres de défaut avec les modules: les manques: ce qui manque à l'image du module à examiner par rapport à l'image du module de référence, et les extensions: ce qui a été ajouté à l'image du module à examiner par rapport à l'image du module de référence.

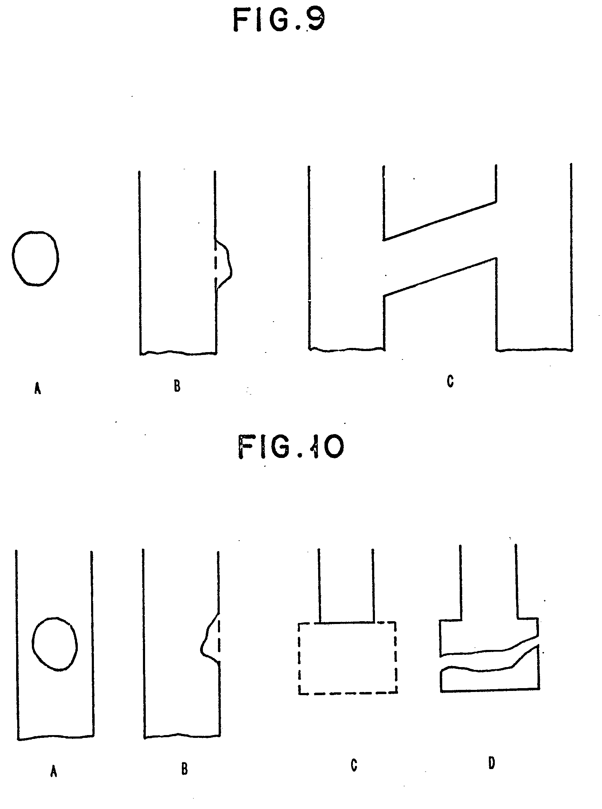

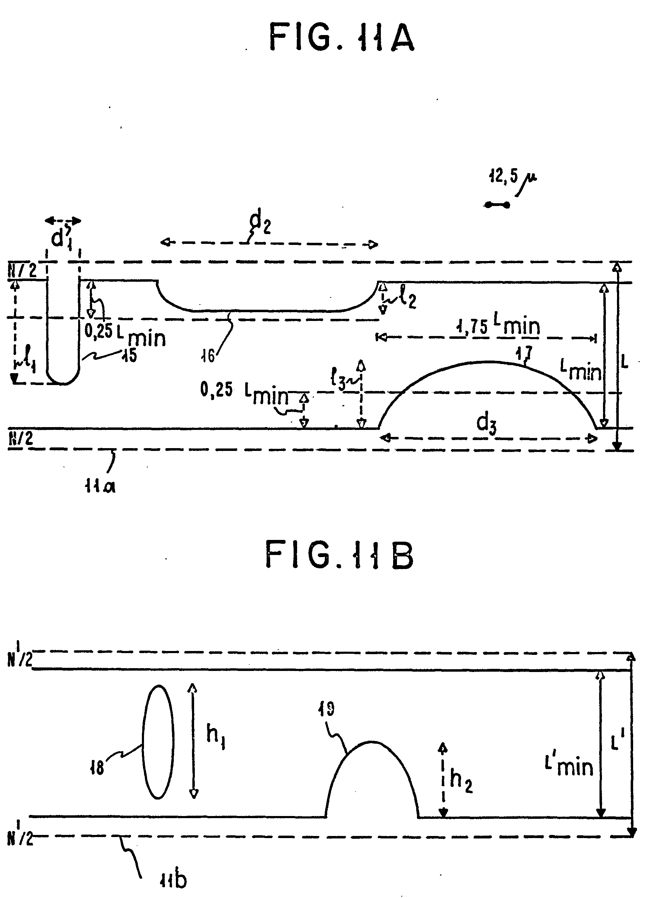

Dans ce domaine, les défauts peuvent prendre diverses formes dont certaines, parmi les plus caractéristiques sont montrées sur les figures 9 et 10.

1) Cas d'une extension
Les défauts peuvent être de trois types:
A) ilot (motif parasite)
B) excroissance le long d'un motif
C) point (entre deux motifs)
ces défauts sont respectivement montrés sur la figure 9, parties A, B et C.

2) Cas d'un manque

Les défauts peuvent être de quatre types:

A) trou, dans un motif

B) échancrure

C) absence totale du motif

C) rupture dans le motif

Ces défauts sont respectivement représentés sur la figure 10, parties A, B, C et D.

S'agissant d'objets présentant des tolérances constantes, il n'y aura que deux critères de rejets qui seront appliqués: relatifs aux défauts du genre manque et aux défauts du genre "extension". On dressera une carte ou image des défauts pour chaque genre de défaut, grâce à un traitement différent des images $I_{REF}$ et $I_{EXA}$ à comparer.

Pour déterminer les défauts du genre "extension" en tenant compte de la largeur maximale tolérée, on dilate $I_{REF}$ de la taille des tolérances dimensionnelles, ce qui donne $(I_{REF})_{max}$, puis on compare avec $I_{EXA}$ en faisant l'opération logique complexe $[(I_{REF})_{max}$ OU $I_{EXA}]$ OU EXCLUSIF $(I_{REF})_{max}$. Si l'ensemble résultant ou image des défauts n'est pas vide, il existe des défauts du genre "extension". Cette opération logique est retenue parce qu'elle permet la sélection des défauts du genre "extension" uniquement.

Pour les défauts du genre "manque" on érode $I_{REF}$ de la taille des tolérances dimensionnelles, ce qui donne $(I_{REF})_{min}$ puis on compare avec $I_{EXA}$ en faisant l'opération logique complexe $[(I_{REF})_{min}$ OU $I_{EXA}]$ OU EXCLUSIF $I_{EXA}$.

Si l'ensemble résultant ou image de défauts n'est pas vide, il existe des défauts du genre "manque". Cette opération logique est retenue parce qu'elle permet la sélection des défauts du type manque uniquement. On remarque que l'élément structurant des opérations de dilatation et d'érosion est identique pour les deux opérations car les tailles des tolérances dimensionelles minimales et maximales sont égales. On obtient donc finalement deux images des défauts l'une mettant en évidence les "extensions", l'autre les "manques".

D'autres opérations logiques peuvent être envisagées, notamment si une seule image de défauts est souhaitée.

5.2 Généralisation au cas des modules présentant des configurations avec des tolérances et des critères variables selon l'emplacement

Avec des modules présentant des tolérances variables selon les emplacements, le principe de traitement qui vient d'être décrit reste le même (étape 5 de la figure 3), le procédé doit être aménagé pour que l'ajustement aux tolérances dimensionnelles et les critères de rejet soient fonction de la région. En d'autres termes l'élément structurant de l'opération 5' assurant l'ajustement aux tolérances variables et les critères de rejet de l'opération 5''' sont essentiellement variables selon l'emplacement. Sur la figure 3 apparaît un dispositif qui porte la référence 7 et qui est essentiel pour la mise en oeuvre de la présente invention. Ce dispositif de synchronisation et d'adressage assure que l'ordre et le contenu des opérations (en temps réel) soient appropriés. En synchronisation avec le balayage de $I_{exa}$ (et eventuellement de $I_{ref}$) il commande pour chaque pixel les opérations d'ajustement aux tolérances dimensionnelles (5') et d'analyse du défaut en regard des critères de rejet pour ce pixel (5'''). Le dispositif 7 est associé à une mémoire qui contient deux tables de données, une pour les défauts du genre "manque", une pour les défauts du genre "extension". La première table contient pour chaque pixel les données: valeur de la tolérance dimensionnelle et les critères de rejet pour ce point. L'analyse des défauts du genre manque ne nécessite en fait que la connaissance de la largeur et de la direction du conducteur contenant le pixel analysé, c'est donc à partir de ces deux informations que les données précitées sont élaborées. Les deux données vont permettre d'ajuster $I_{REF}$ aux tolérances dimensionnelles et de fournir les critères de rejet pour chaque pixel. Les informations relatives à la largeur et à la direction des conducteurs sont donc préalablement déterminées, elles servent de base au calcul des données utiles: valeur de la tolérance et critères de rejet, qui seront stockées dans une mémoire sous la forme d'une première table de données.

De même l'analyse des défauts du genre "extension" nécessite le stockage dans une mémoire d'une deuxième table qui contient les données utiles: valeur de la tolérance et critères de rejet pour chaque pixel de l'image, calculés à partir des informations: largeur et direction de l'espace inter-conducteurs.

En d'autres termes, la première table sera constituée à partir de $I_{REF}$ alors que la deuxième table sera constituée à partir de $I_{REF}^c$.

Dans l'application aux modules représentés sur la figure 1A, on a vu que les conducteurs pouvaient présenter trois largeurs: 100, 125 et 250 μ et quatre directions: 0, 45, 90 et 135°. Pour chaque pixel d'un conducteur déterminé de $I_{REF}$, il faut déterminer la largeur et la direction du conducteur qui le contient. Pour cela on calcule le nombre de pixels selon chacune des quatre directions appartenant à ce conducteur. Un programme informatique doit permettre de déterminer sans intervention manuelle, la largeur et l'orientation du conducteur. Ce procédé demande environ 16 bits par pixel, soit 4,2 millions de mots de 16 bits pour $I_{REF}$.

Cette quantité est évidemment trop importante vis-à-vis de la place mémoire disponible pratiquement dans la mémoire. On peut alors réduire ce nombre en décomposant $I_{REF}$ en régions. Ces régions sont de préférence les carrés d'un damier qui se superposent virtuellement à $I_{REF}$. A chaque carré du damier seront associés une tolérance dimensionnelle et les critères de rejet, respectivement pour les défauts du genre "manque" et du genre "extension". On choisit pour chaque carré une taille de $16 \times 16$ pixels, ce qui ne donne plus que 16984 mots de 16 bits à stocker. Cette taille de carré à été choisie de façon à optimiser la place mémoire nécessaire et de manière à ce que la densité de conducteurs à l'intérieur du carré soit minimale: deux conducteurs par carré au maximum. Cependant l'invention n'est pas limitée à ce choix. Si la taille du carré permet d'avoir deux (ou plus) conducteurs par carré, on pourra se baser sur les régles suivantes: si les deux conducteurs sont identiques, les largeurs et directions calculées pour tous les pixels du carré sont identiques. Le critère de rejet et la largeur de la tolérance dimensionnelle se déduisent facilement de ces valeurs. Dans le cas où les deux conducteurs ont des largeurs et/ou des directions différentes, on retiendra la plus petite valeur des tolérances calculées pour tous les pixels du carré et le critère de rejet le plus strict.

5.2.1 Règles d'établissement et contenu des tables de données pour les deux genres de défauts
  1) Défauts du genre "manque"

Pour chaque largeur de conducteur, les instructions de contrôle définissent la taille acceptable des défauts. Des paramètres autres que la largeur peuvent également être pris en compte, par exemple: la longueur du défaut pour une largeur déterminée du conducteur. Par exemple on peut trouver les instructions suivantes pour un conducteur dont la largeur nominale L est égale à 125 µ.

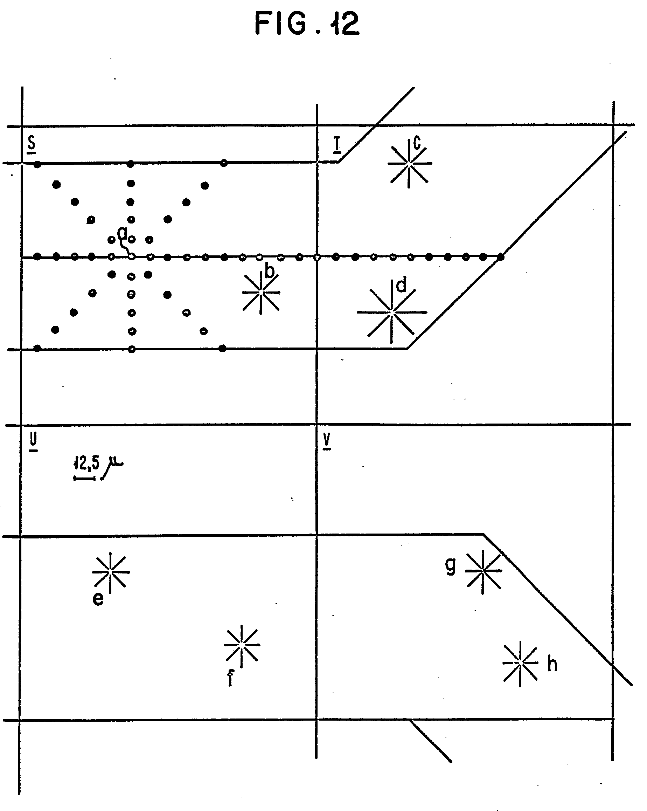

Pour être acceptable un défaut ne doit pas réduire la largeur du conducteur de plus de $X\%=25\%$. Cependant, si le défaut réduit la largeur de plus de 25%, il est accepté si sa longueur d est inférieur ou égale à kL (k=1,75), mais en aucun cas il ne doit réduire la largeur du conducteur à une valeur inférieure à une valeur minimale qui est $A=25$ µ. Les paramètres X, k, et A qui varient évidemment avec les largeurs des conducteurs, constituent donc la base des critères de rejet pour chaque carré. En fait, pour assurer une garantie supplémentaire ces instructions seront appliquées par comparaison non avec $I_{REF}$ mais avec $(I_{REF})_{min}$ (c'est-à-dire après ajustement de l'image de référence aux tolérances dimensionnelles N). Sur la figure 11A on a représenté une portion de conducteur de largeur nominale $L=125$ µ supposée contenue dans un même carré. La largeur du conducteur est ajustée aux tolérances dimensionnelles minimales ($N=25$ µ pour $L=125$ µ) sa largeur devient donc $L_{min}=100$ µ. Trois défauts sont représentés. Le défaut 15 est acceptable bien que sa largeur $l_1$ soit supérieure à $0,25 L_{min}$, sa longueur $d_1$ est inférieure à $1,75 L_{min}$ et il ne réduit pas la largeur du conducteur 11a, à sa valeur minimale 25 µ. Le défaut 16 dont la largeur $l_2$ est inférieure à $0,25 L_{min}$ est acceptable on note qu'il peut avoir une longueur $d_2$ quelconque. Le défaut 17 est acceptable également pour les mêmes raisons que le défaut 15. On rappelle que si dans un carré la largeur du conducteur se modifie, par exemple passe de 125 µ à 250 µ, on prendra la tolérance dimensionnelle et les critères de rejet les plus défavorables.

En fait comme les conducteurs ont quatre directions possibles, 0, 45, 90 et 135°, on calculera les projections du défaut de manque dans la direction du conducteur (largeur l du défaut) et dans la direction perpendiculaire (longueur d du défaut). Cette détermination est importante, les critères de rejet étant essentiellement basés sur la comparaison de d et l avec $k L_{min}$ et $X\% L_{min}$, $L_{min}-A$ respectivement, pour une orientation ($\theta$) déterminée.

En résumé, en ce qui concerne l'image des défauts du genre "manque", on peut associer pour chaque carré une tolérance dimensionnelle (N) fonction de la largeur du conducteur (L ou $L_{min}$) et des critères de rejet fonctions de cette largeur et de sa direction ($\theta$).

2) Défauts du genre "extension"
Tout ceci reste valable pour l'image des défauts du genre "extension". Lorsqu'on analyse l'image complémentaire du module de référence, on obtient alors la largeur et la direction de l'espace interconducteurs pour chaque pixel de $I_{REF}^c$. Les pixels appartenant aux conducteurs n'interviennent plus dans la définition des critères de rejet pour les défauts du genre "extension". La dilatation de $I_{REF}$ s'effectue selon les instructions de contrôle en fonction de la largeur de l'espace interconducteurs considéré, cela revient à établir également une valeur (N') des tolérances dimensionnelles pour l'espace interconducteur qui joue le même rôle que celle (N) établie pour la largeur des conducteurs. Il faut noter que dilater les conducteurs de $I_{REF}$ de N' revient à éroder l'espace interconducteurs de N'. Dans certains carrés il est possible que $N=N'$. En ce qui concerne les critères de rejet le principe en est le suivant: tout défaut doit laisser un espace interconducteur cumulatif minimal B déterminé par les instructions de contrôle (la longueur peut être quelconque). En fait ici également c'est sa projection h dans la direction de l'espace interconducteur qui est prise en considération. $I_{EXA}$ sera comparé à $(I_{REF})_{max}$ image de référence dilatée de N': tolérance dimensionnelle pour la largeur nominale L' de l'espace interconducteurs. Le critère de rejet dans ce cas devient $X \leq L'_{min}-B$ où $L'_{min}$ est la valeur de l'espace interconducteur L' après érosion aux tolérances dimensionnelles N', B varie évidemment selon la largeur de l'espace interconducteurs considéré par exemple $B=25$ µ pour un espace $L'_{min}=100$ µ. Sur la figure 11B, on a représenté un espace interconducteurs 11b et deux défauts acceptables 18 et 19 dont les projections $h_1$ et $h_2$ vérifient la règle $\leq L'_{min}-B$. Lorsque les pixels d'une même zone présentent deux espaces interconducteurs de largeurs différentes, la taille de la dilatation (N') et les critères de rejet sont ceux de l'espace interconducteur le plus étroit. Lorsque dans un carré, un a des espaces interconducteurs de même largeur mais de directions

**0 054 596**

différentes, il faut calculer les projections du défaut dans les quatre directions, et dans chacune des directions la règle doit être vérifiée.

Lorsque dans un carré il y a deux espaces interconducteurs de largeurs et de directions différentes, la taille de la dilatation et les critères de rejet seront ceux de l'espace le plus étroit.

On comprend que les tolérances dimensionnelles (N et N') comme les critères de rejet conduisent à des valeurs qui ne peuvent être que des multiples du pas d'échantillonnage (ici de 12,5 $\mu$).

On aboutit finalement à deux tables de données qui se présentent de la façon suivante:

Table de données No. 1 correspondant aux défauts du genre "manque".

Pour chaque carré, les paramètres $\theta$, X, A, k et L sont combinés entre eux à l'aide d'un calculateur pour représenter les critères de rejet, qui comme on l'a vu ci-dessus sont essentiellement fonctions de $\theta$, $L_{min}-A$, X% $L_{min}$ et k $L_{min}$.

| Numéro du carré | Tolérances dimensionnelles | Critères de rejet |
|---|---|---|
| 1 | $N_1$ | $\theta_1$, $L_{1\ min}-A_1$, $X_1\%\ L_{1\ min}$, $k_1\ L_{1\ min}$ |
| 2 | $N_2$ | $\theta_2$, ... |
| . | | |
| . | | |
| . | | |
| n | $N_n$ | $\theta_n$, $L_{n\ min}-A_n$, $X_n\%\ L_{n\ min}$, $k_n\ L_{n\ min}$ |

Pour le carré No. i, la tolérance dimensionnelle utile pour procéder à l'érosion de $I_{REF}$, est $N_i$ et les critères de rejet sont $\theta_i$, $L_{i\ min}-A_i$, $X_i\%\ L_{i\ min}$, $k_i\ L_{i\ min}$ qui donnent l'orientation et la taille des défauts acceptables. Une table de défaut No. 2 (genre "extension") similaire est également établie. Pour le carré No. i, on trouvera la tolérance dimensionnelle $N'_i$ et les paramètres $\theta_i$ et $B_i$.

5.2.2 Modes d'Etablissement des tables de données

Quand le nombre de carrés n'est pas très important, par exemple inférieur à 100, un opérateur peut examiner le module de référence et en superposant virtuellement un damier, entrer dans la mémoire ces différents paramètres. Cependant, dès que ce chiffre est dépassé, il est plus intéressant de recourir à un système de génération automatique de ces tables contenant les tolérances dimensionnelles et les critères de rejet. Ces tables seront adressées grâce à une technique particulière d'adressage du damier. Le contenu de ces table est établi à partir d'une technique basée sur le calcul des plus grandes longueurs de traversée.

Les tables seront chargées automatiquement lors d'une étape préliminaire par analyse de $I_{REF}$ comme on va le décrire ci-après. Ensuite, lors de l'inspection et du tri de chaque module à examiner, à chaque pixel de $I_{EXA}$ on associera les données correspondant au carré qui le contient.

Génération automatique des tables de données
1) Mode d'adressage du damier

Le présent procédé impose l'adressage simultané des coordonnées X et Y du point analysé et du carré qui le contient pour que les mots correspondants stockés en mémoire puissent être disponibles et agir après décodage dans le cadre des différentes opérations de l'étape 5. Un exemple sera explicité avec une image de 16×16 pixels (256 points image) et avec un damier de seize carrés; la dimension de chaque carré étant de 4×4 pixels.

Le mot à l'adresse

0000      contient les données du carré No. 1

0001      contient les données du carré No. 2

    .
    .

1111      contient les données du carré No. 16

10

L'adressage X se fait sur 4 bits A, B, C, D, l'adressage Y se fait également sur 4 bits E, F, G, H. On associe les deux bits de plus fort poids de X(AB) aux deux bits de plus fort poids de Y(EF), on forme un mot de quatre bits EFAB qui correspond à l'adresse du carré du damier désiré.

Le tableau ci-dessous montre la construction

| | | | X | | | | | | | | | | | | | |
|---|---|---|---|---|---|---|---|---|---|---|---|---|---|---|---|---|
| D | 0 | 1 | 0 | 1 | 0 | 1 | 0 | 1 | 0 | 1 | 0 | 1 | 0 | 1 | 0 | 1 |
| C | 0 | 0 | 1 | 1 | 0 | 0 | 1 | 1 | 0 | 1 | 0 | 0 | 1 | 1 | 0 | 0 |
| B | 0 | 0 | 0 | 0 | 1 | 1 | 1 | 1 | 0 | 0 | 0 | 0 | 1 | 1 | 1 | 1 |
| A | 0 | 0 | 0 | 0 | 0 | 0 | 0 | 0 | 1 | 1 | 1 | 1 | 1 | 1 | 1 | 1 |
| | ↑ | ↑ | ↑ | ↑ | ↑ | ↑ | ↑ | ↑ | ↑ | ↑ | ↑ | ↑ | ↑ | ↑ | ↑ | ↑ |

| EFGH | | | | |
|---|---|---|---|---|
| 0000 — | adresse | | | |
| 0001 — | du carré | | | |
| 0010 — | No. 1 | No. 2 | | |
| 0011 — | 0000 | 0001 | 0010 | 0011 |
| 0100 — | | | | |
| 0101 — | | | | |
| 0110 — | 0100 | 0101 | 0110 | 0111 |
| 0111 — | | | | |
| Y 1000 — | | | | |
| 1001 — | | | | |
| 1010 — | 1000 | 1001 | 1010 | 1011 |
| 1011 — | | | | |
| 1100 — | | | | |
| 1101 — | | | | |
| 1110 — | 1100 | 1101 | 1110 | 1111 |
| 1111 — | | | | No. 16 |

A l'adresse 0011 on trouve dans la mémoire adressable, la tolérance dimensionnelle et les critères de rejet correspondants à la zone de $I_{REF}$ recouverte par le carré No. 4 du damier.

2) Principe et calcul des longueurs de traversée pour chaque pixel de $I_{REF}$-élaboration des tables de données.

A partir de l'image binaire du module de référence $I_{REF}$, on affecte à chaque pixel, 4 paramètres que l'on met dans une table intermédiaire de quatre mots. Ces quatre paramètres correspondent à la longueur en nombre de pixels de la traversée du conducteur suivant chacune des quatre directions 0, 45, 90 et 135°, traversant le pixel. On appelle longueur de traversée d'un pixel de valeur 1, dans une direction, le nombre de pixels consécutifs égaux à 1 qui se trouvent sur l'axe traversant ce pixel dans la direction considérée.

Pour une matrice de 2048×2048 pixels, en choisissant des carrés de 16×16 pixels, il y a donc 128×128 carrés. Sur la figure 12 on a représenté quatre carrés adjacents, parmi les 16384 carrés du damier,

11

référencés S, T, U, V. Dans ces carrés, on a représenté schématiquement deux portions de conducteurs. Le calcul des plus grandes traversées pour les différents pixels référencés a, b, c, d, e, f, g et h permet d'établir un fragment de ladite table intermédiaire, qui est donnée ci-dessous:

| Réf. pixel par carré | Long. traver-sées selon orien-ta-tion | $t_1$ (0°) | $t_2$ (45°) | $t_3$ (90°) | $t_4$ (135°) |
|---|---|---|---|---|---|
| a ........... | | 27 | 11 | 11 | 11 |
| b ........... | | 25 | >14 | 11 | 11 |
| c ........... | | 32 | >13 | 15 | 8 |
| d ........... | | 24 | >13 | 14 | 10 |
| e ........... | | >28 | 11 | 11 | 11 |
| f ........... | | >32 | 11 | 11 | 11 |
| g ........... | | >28 | 10 | 15 | >10 |
| h ........... | | >33 | 7 | 15 | >13 |

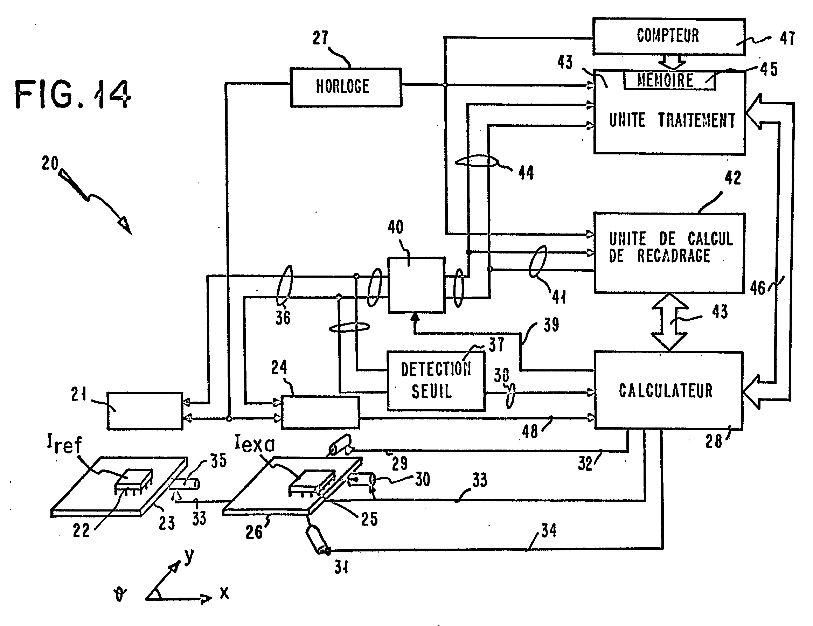

La table intermédiaire comprend les longueurs de traversée de tous les pixels de valeur 1 de l'image. Le calcul se fait automatiquement de la façon suivante (voir figure 13).

On balaie l'image de gauche à droite à partir du premier point blanc (valeur binaire 1) de l'image, on compte le nombre de points blancs consécutifs dans la direction jusqu'à la sortie du motif et on affecte à chacun des pixels rencontrés ce même nombre là pour leurs traversées horizontales (e et g par exemple auront la même longueur de traversée dans la direction 0°). Cette longueur de traversée est donc stockée en mémoire dans le premier mot de la table, respectivement pour chaque pixel, et on continue sur la même ligne pour le motif suivant. On répète l'opération pour les lignes suivantes dans l'image.

Pour la direction verticale, on analyse de la même façon l'image du bas vers le haut et de gauche à droite et on affecte la longueur de traversée verticale pour chaque pixel dans le deuxième mot de la table.

Pour la direction diagonale à 45°, on balaie l'image dans cette direction de la gauche vers la droite. On affecte la longueur de traversée du troisième mot de la table pour chaque pixel.

Pour la diagonale à 135° on affecte le quatrième paramètre au quatrième mot de la table.

Ainsi, on associe à chaque pixel de valeur 1 une première table intermédiaire comprenant les quatre traversées blanches selon les quatre directions. Aux pixels de valeur 0 (substrat céramique du module) on affectera la valeur 0 aux quatre paramètres. Ils n'auront aucun poids dans la définition de la tolérance dimensionnelle et des critères de rejet pour les défauts de "manque".

Pour chaque pixel: un calculateur sélectionne la plus grande des quatre traversées et en déduit la direction (θ) du conducteur, quant à la longueur de traversée dans la direction perpendiculaire, elle définit la largeur du conducteur (L). Par exemple, pour le pixel e du carré U, on avait trouvé $t_1$ supérieur à 28, $t_2$ étal à 11, $t_3$ égal à 11, $t_4$ est égal à 11. Tous les pixels de ce carré ont des longueurs de traversée correspondantes du même ordre de grandeur (cf. les pixels e et f). Le calculateur en déduit que le conducteur du carré U a une largeur de 10 pas soit 125 μ selon la direction 0°. Le programme qui assure ce calcul ne pose aucune difficulté pour l'homme de l'art et ne sera donc pas décrit ici.

Pour chaque carré de 16×16 pixels, on a finalement deux données: largeur et direction du conducteur. Dans la plupart des cas, ces 256 pixels donneront les mêmes résultats. On pourra déduire facilement la largeur et la direction du conducteur présent dans ce carré à partir des longueurs de traversée de ces pixels. Ce calcul est effectué par un calculateur pour chaque carré.

La tolérance dimensionnelle $N_i$ dans ce carré No. i est directement fonction de la largeur $L_i$ du conducteur dans ce carré. Elle est donc facilement déterminée par le calculateur. Les dimensions et l'orientation de la fenêtre d'analyse sont également fonction de l'orientation $\theta_i$ et de la largeur du conducteur $L_i$, elles seront donc également déterminées par le calculateur, sous la forme des critères de rejet déjà vus: $\theta_i$, $L_{i\ min}-A_i$, $X\%_i$ $L_{i\ min}$ et $k_i L_{i\ min}$ avec $L_{i\ min}=L_i-N_i\%\ L_i$

Dans les cas particuliers où les 256 pixels ne donnent pas les mêmes résultats, les règles suivantes doivent s'appliquer:

**1er Cas:**

Les conducteurs ont la même direction, mais une largeur différente. Les critères de rejet sont ceux correspondants au conducteur le moins large.

La taille d'érosion de la zone pour l'ajustement aux tolérances dimensionnelles minimales est celle correspondant au conducteur le moins large.

**2ème Cas:**

Les conducteurs ont la même largeur mais sont de directions différentes. (C'est le cas du carré T de la figure 12).

Le critère de rejet va être plus strict. Les projections doivent avoir une taille limite qui est dans ce cas $(X\% \ L_{min})-A$, avec

$L_{min}$ largeur du conducteur après érosion,
A et X définis plus haut, sont fonctions de L.

**3ème Cas:**

Les conducteurs sont de largeur et de direction différentes. La taille d'érosion pour l'ajustement aux tolérances dimensionnelles et celle correspondant au conducteur le moins large. Le critère de rejet est défini comme dans le deuxième cas, $L_{min}$ correspondant à la largeur du conducteur le moins large.

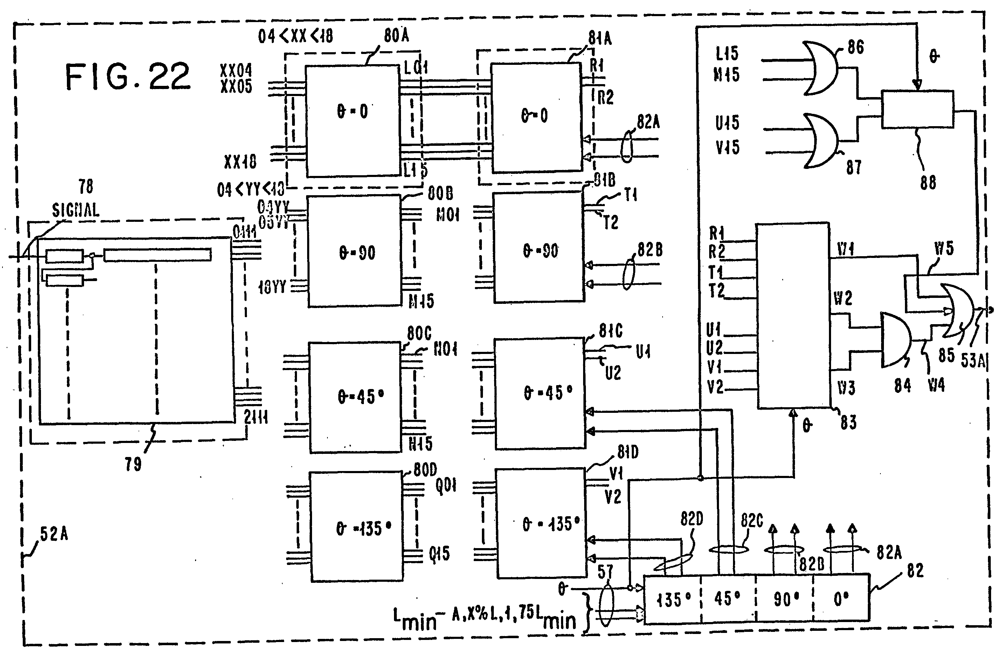

Dans le présent mode de réalisation, dans le but de simplification de l'exposé, on considère que l'on est dans le cas général ou le premier cas particulier, c'est-à-dire, que seules deux projections sont calculées, l'homme de métier adaptera les circuits de la figure 22 et en particulier le multiplexeur 83, si les situations décrites dans les deuxième et troisième cas particuliers sont susceptibles de se produire.

Pour l'image complémentaire, on procède de façon identique, ce qui fournit les éléments d'une deuxième table intermédiaire pour les défauts du genre "extension" à partir de laquelle le calculateur établira de façon identique les données de la table No. 2.

On sait que les données de la table No. 1 agissent d'abord sur la taille de l'élément structurant lors de l'opération d'érosion (5') pour fournir $(I_{REF})_{min}$ pour chaque carré. $(I_{REF})_{min}$ et $I_{EXA}$ sont alors comparées selon les opérations logiques complexes décrites ci-dessus (voir 5.1). On aboutit à l'image des défauts du genre "manque".

On compare alors le défaut détecté dans un carré avec les critères de rejet contenus dans la table No. 1 qui lui correspondent. Pratiquement cela revient à comparer les valeurs d et I caractérisant le défaut avec les données $X\% \ L_{min}$, $L_{min}-A$, k $L_{min}$, selon les régles établies plus haut.

On procédé de façon similaire à partir de la table No. 2 dont les données agissent d'abord sur la taille de l'élément structurant lors de l'opération de dilatation (5') pour fournir $(I_{REF})_{max}$ pour chaque carré. $(I_{REF})_{max}$ et $I_{EXA}$ sont alors comparées selon les opérations logiques complexes décrites ci-dessus (voir 5.1). On about à l'image des défauts du genre "extension".

On compare alors chaque défaut détecté dans un carré avec les critères de rejet contenus dans la table No. 2 qui lui correspondent. Pratiquement cela revient à comparer la valeur h caractérisant le défaut avec la donnée $L'_{min}-B$ selon les régles établies plus haut. Le résultat de cette comparaison fournit les éléments de décision bon/rejet pour l'étape de tri.

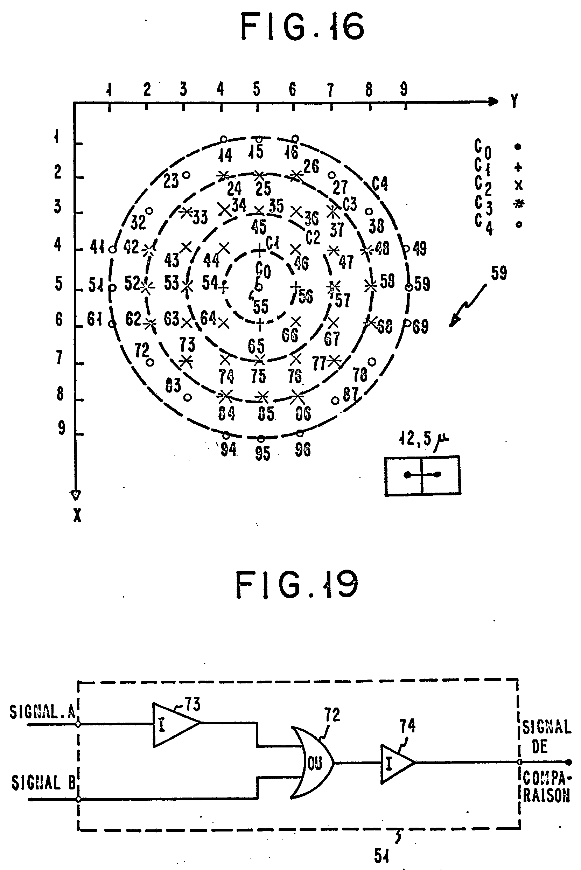

Chaque carré a donc ses propres critères de rejet applicables à tous les pixels qu'il contient, dont on vient de voir le mode de détermination. Il faut comprendre que dans certains cas un même défaut peut impliquer non pas un carré, mais deux (ou plus) s'il se trouve par exemple dans deux carrés adjacents. Le cas ne pose pas de problème, chaque pixel du défaut sera analysé par la fenêtre d'analyse avec les critères de rejet du carré qui lui correspond. Par ailleurs la taille de la fenêtre d'analyse est indépendante de la taille des carrés. Par exemple, dans la présente demande on a choisi des carrés de 16 pixels×16 pixels et une fenêtre d'analyse constituée par un carré de 15 pixels×15 pixels avec quatre axes de symétrie. Cette fenêtre aura la forme d'une étoile à huit branches (en raison des quatre symétries 0, 45, 90 et 135°) dont la plus grande dimension est 21 pixels (elle est représentée sur la figure 16).

**6. Le Tri**

Les modules jugés bons, c'est-à-dire sans défaut ou présentant des défauts tolérables au vu des critères de rejet sont acceptés à ce niveau.

**III. Equipement et circuits de mise en oeuvre**

Le procédé de traitement numérique des images de l'objet de référence et de l'objet à examiner tel qu'il est décrit dans la partie II de la présente demande, peut trouver application dans des domaines très divers comme on l'a écrit ci-dessus et en particulier dans l'industrie des semi-conducteurs, où il peut être notamment utilisé pour le tri automatique des modules, dont certains motifs, tels que les lignes conductrices présentent des tolérances dimensionnelles et des critères de rejet variables avec l'emplacement. En ce qui concerne les modules, les images sont très contrastées (pratiquement noires et blanches), dans ce cas la détection automatique du seuil peut se faire sans difficulté ainsi que le recadrage.

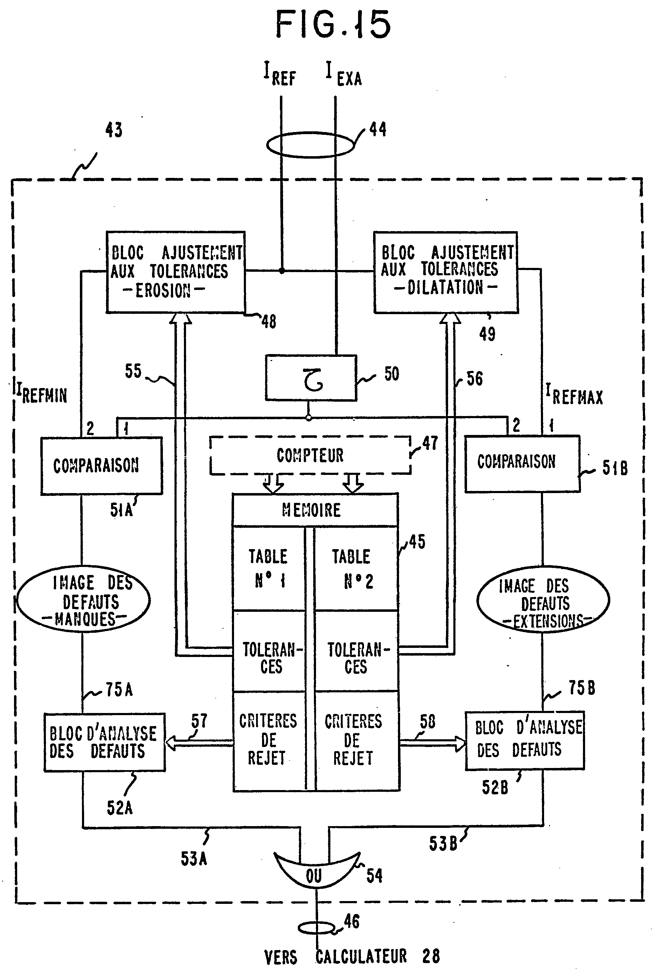

Un exemple d'équipement approprié va être décrit ci-dessous, par référence à la figure 14 qui représente le bloc diagramme des principales fonctions utilisées dans un mode de réalisation particulier.

**0 054 596**

L'équipement 20 peut être réalisé avec différents capteurs selon les applications. Le capteur utilisé dans cette demande est une barrette de 2048 photodiodes intégrées du type fabriqué par RETICON que permet l'acquisition complète d'une ligne de 2048 bits. Un capteur 21 balaye le module de référence 22 porté par un support 23 et un capteur 24 balaye le module à examiner 25 porté par un support orientable 26. Ces capteurs élaborent respectivement $I_{ref}$ et $I_{exa}$, et sont sous le contrôle de l'horloge 27. Le module de référence et le module à examiner sont préalablement recadrés à l'aide de marquers ou repères préalablement à l'opération d'inspection et de tri, proprement dite, soit à l'aide d'un équipement différent de celui représenté (du genre appareil d'alignement des masques) soit avec l'équipement représenté. Au début de cette opération, le module à examiner 25 est convoyé et disposé automatiquement sur son support, cette opération assure un préalignement. Le programme placé dans le calculateur 28 commande les moteurs 29, 30 et 31 de recadrage en X, Y et θ du module 25 à travers les lignes 32, 33 et 34, pour que les repères disposés sur les modules 22 et 25 puissent être analysés. Le support 23 est commandé en synchronisme par le moteur 35 pour le déplacement en Y.

Les signaux analogiques représentatifs de $I_{ref}$ et de $I_{exa}$ issus des capteurs 21 et 24 sont transmis respectivement par le bus 36 à un bloc de détection de seuil 37 où ils sont analysés. Le bloc 37 établit les histogrammes en intensité de $I_{exa}$ (répartition des gris) et les communique par le bus 38 au calculateur 28 qui détermine le seuil $N_{TH}$ de l'image $I_{exa}$. Cette valeur est alors affichée par le bus 39 à l'entrée du bloc 40, qui reçoit par ailleurs les signaux analogiques issus des capteurs par le bus 36. A la sortie du bloc 40 les images $I_{exa}$ et $I_{ref}$ sont seuillées, chaque point image a la valeur binaire 0 ou 1. Les images binaires obtenues référencées $I_{REF}$ et $I_{EXA}$ sont transmises par le bus 41 à l'unité de calcul de recadrage 42 qui recadre $I_{REF}$ et $I_{EXA}$, par exemple avec le procédé décrit ci-dessus (1.4).

Il faut remarquer que pour une famille de modules déterminée, c'est-à-dire présentant une même configuration de conducteurs, la valeur du seuil peut être déterminée une fois pour toute et cette valeur affichée en permanence dans le bloc 40 pour tous les modules à examiner de cette famille.

Egalement il n'y a pas d'inconvénient à inclure cette fonction "calcul du recadrage" dans le calculateur 28.

Quand le recadrage est nécessaire, les éléments utiles sont transmis par le bus 43 au calculateur 28 qui calcule les déplacements en X, Y et θ à commander. Les moteurs 30 et 33 qui commandent les déplacements en Y des modules 22 et 25, sont du type pas-à-pas ($\Delta Y = 12,5\ \mu$ pour assurer que la matrice de 2048 lignes, de 2048 bits qui a été choisie comme exemple, soit bien obtenue).

Dans un autre mode de réalisation, $I_{REF}$ peut être contenue dans une mémoire de quatre millions de bits (voir figure 3) qui sont adressés par un compteur de 22 bits, sous la commande de l'horloge 27. Un générateur de configurations du type Gerber peut fournir directement cette image électronique représentative par exemple du masque de métallisation. Cette image électronique est recadrée, en cas de besoin dans les mêmes conditions que précédemment.

L'unité de traitement 43 reçoit alors par le bus 44 des images électroniques $I_{REF}$ et $I_{EXA}$ parfaitement cadrées. Cette unité comporte une mémoire 45 qui est préalablement chargée par les tables de données No. 1 et No. 2, c'est-à-dire qui contient pour chaque carré la tolérance dimensionnelle et les critères de rejet. Cette unité assure toutes les opérations mentionnées à l'étape (1.5): ajustement aux tolérances dimensionnelles de $I_{REF}$, comparaison entre $I_{REF}$ ajustée et $I_{EXA}$, élaboration des images des défauts et analyse desdits défauts au vu des critères de rejet. Elle fournit au calculateur les éléments de décision bon/rejet par le bus 46.

Cette unité est pilotée par l'horloge 27, qui pilote également un double compteur 47 de 22 bits. Ce double compteur est câblé de façon à tenir compte du retard nécessaire à la sortie des données relatives à l'ajustement aux tolérances (effectué avant l'opération de comparaison) et la sortie des données relatives à l'analyse des défauts au vu des critères de rejet (effectuée après l'opération de comparaison). Ce compteur peut faire partie intégrante ou non de l'unité de traitement. Le contenu de ce compteur est la représentation binaire en X et en Y du point de $I_{EXA}$ en cours d'analyse. Il suffit en effet, de compter le nombre d'impulsions de l'horloge pour chaque ligne pour déterminer l'adresse en X (qui correspond à une des 2048 diodes) et le nombre d'impulsions de fin de ligne (toutes les 2048 impulsions) pour déterminer l'adresse en Y. Conformément à ce qui a été dit, ci-dessus, les sept bits (parmi onze) de poids le plus fort de l'adresse en X et les sept bits (parmi les onze) de poids de plus fort de l'adresse en Y sont combinés pour former une adresse, cette adresse correspond à un carré, et à cette adresse on trouve les données correspondantes qui définissent la tolérance dimensionnelle et le critère de rejet pour ce carré.

Cette unité de traitement et le compteur permettent donc d'ajuster en temps réel la tolérance dimensionnelle et les critères de rejet en fonction des coordonnées X et Y du points analysé du module à examiner, donc d'associer à chaque pixel de $I_{EXA}$, le pixel correspondant de $I_{REF}$ et les données contenues dans la mémoire qui lui correspondent.

Après le balayage d'une ligne par les capteurs, le calculateur détecte la fin de balayage par la ligne 48 (il compte 2048 bits ou reçoit un signal de fin de ligne) et commande les moteurs 30 et 35 pour un déplacement $\Delta Y = 12,5\ \mu$, en vu du balayage de la ligne suivante. Le contenu de la mémoire 45 peut être chargé soit manuellement soit automatiquement à partir de cet équipement au cours d'une étape préliminaire.

L'unité de traitement 43 est détaillée sur la figure 15. Elle comporte la mémoire 45 qui a été préalablement chargée avec les tables de données No. 1 et No. 2 et le compteur 47 qui permet d'associer à

14

chaque pixel analysé les données correspondantes au carré qui le contient. Elle comporte en outre les différents blocs d'ajustement aux tolérances dimensionnelles de comparaison, et d'analyse de défauts. Le principe de traitement est le suivant: $I_{EXA}$ et $I_{REF}$ arrivent par le bus 44, $I_{EXA}$ est ajusté aux tolérances dimensionnelles minimales et maximales respectivement dans les blocs 48 et 49 pour fournir respectivement $(I_{REF})_{min}$ et $(I_{REF})_{max}$. Ces images sont comparées avec $I_{EXA}$ (préalablement retardée dans la ligne à retard 50) dans les circuits de comparaison 51A et 51B. Les images des défauts résultants du genre "manque" et du genre "extension" sont analysées dans les blocs d'analyse de défauts 52A et 52B. Les résultats des analyses sont disponibles sur les bus 53A et 53B, puis à travers le circuit OU 54 sur le bus 46 qui est relié au calculateur 28.

Les blocs d'ajustement 48 et 49 comportent des circuits de décodage qui sont reliés à la mémoire par les bus 55 et 56 pour ajuster les tailles d'érosion et de dilatation, variables par définition. De même, les blocs d'analyse de défauts 52A et 52B comportent également des circuits de décodage qui sont reliés à la mémoire respectivement par les bus 57 et 58 pour ajuster les critères de rejet, variables par définition.

Les circuits constitutifs du compteur et des blocs d'ajustement, et d'analyse sont pilotés par l'horloge 27.

Il faut tenir compte du fait que les opérations d'analyse de défauts s'effectuent après les opérations d'ajustement aux tolérances, le double compteur 47 comporte les circuits de retard appropriés (non représentés).

La figure 16 représente un élément structurant 59 de forme circulaire échantillonné selon une trame carrée et développé autour d'un pixel central référencé 55. (Un pixel référencé ij signifie que sa coordonnée est i selon l'axe des X et j selon l'axe des Y). On a choisi le cercle comme élément structurant en raison de sa parfaite symétrie selon toutes ses directions. L'élément structurant 59 est en fait constitué par le pixel central 55, et par quatre couronnes référencées C1, C2, C3 et C4, les pixels appartenant à une même couronne sont identifiés par un même signe distinctif.

Un pixel est représenté par un point sur la figure 16, il faut comprendre qu'avec une barette de photodiodes, utilisée comme capteur, la représentation exacte aurait été un carré de 12,5 µ de côté centré sur ce pixel. Avec d'autres capteurs, cette représentation ponctuelle peut être exacte.

La taille de l'élément structurant varie de 1 à 4 fois le pas, c'est-à-dire qu'avec l'élément structurant de la figure 16 on peut ajuster selon les tolérances suivantes: N=25 µ, 50 µ, 75 µ et 100 µ (voir la figure 11A par exemple). Si l'élément structurant est limité au pixel 55 ou couronne C0 l'image transformée sera identique à l'image initiale, si par contre on désire ajuster un conducteur aux tolérances 75 µ, il faudra constituer un élément structurant composé des couronnes C0, C1, C2 et C3. Ce sont les données figurant dans les tables de données qui après décodage vont commander le nombre de couronnes requis.

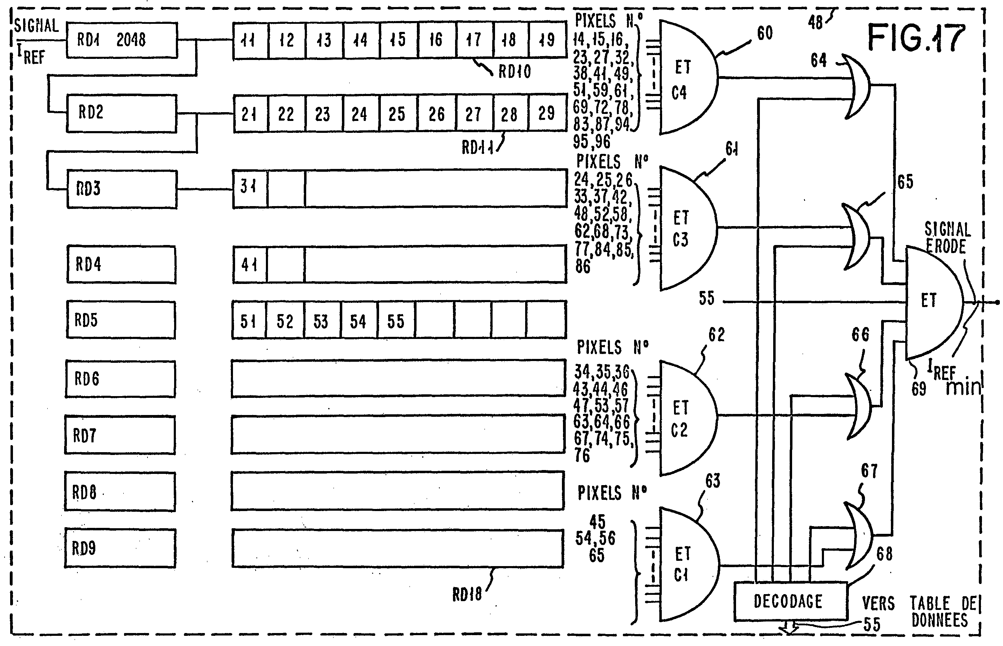

Le circuit décrit sur la figure 17 est avantageux, car plus le nombre de couronne augmente, plus l'élément structurant se rapproche du cercle.

Le bloc d'ajustement aux tolérances minimales qui porte la référence 48 sur la figure 15 est détaillé sur la figure 17. Ce bloc assure l'opération d'érosion avec l'élément structurant montré sur la figure 16. Il comporte neuf registres à décalage RD1 à RD9 de 2048 bits alimentés séquentiellement. Ces registres mémorisent une partie de l'image $I_{REF}$. Chacun de ces registres attaque un registre à décalage de neuf bits à sorties parallèles. Soit neuf registres RD10 à RD18 à neuf bits sont utilisés pour réaliser l'élément structurant de la figure 16 qui se développe sur neuf lignes et neuf colonnes. A un instant donné, alors que l'image est chargée dans le registre RD1 à RD9, les numéros des pixels chargés dans les cellules des registres RD10 à RD18 sont montrés sur la figure 17. Les cellules dont le contenu intervient pour la définition de l'élément structurant 59 sont connectées à l'un des quatre circuits 60 à 63 selon la couronne dont le pixel fait partie. Par exemple sur la figure 16, on voit que la couronne C4 comporte les pixels dont les numéros suivantes: 14, 15, 16, 23, 27, 32, 38, 41, 49, 51, 59, 61, 69, 72, 78, 83, 87, 94, 95, 96. Les sorties des cellules portant ces numéros sont donc connectées aux entrées de la porte ET 60. Il est fait de même pour les trois autres couronnes C3, C2 et C1 qui correspondent respectivement aux circuits ET 61, 62 et 63. Les sorties des circuits ET 60 à 63 sont reliées respectivement aux circuits OU 64 à 67. Chacun de ces circuits est commandé par un circuit de décodage qui est relié par le bus 55 à la table de données No. 1 contenue dans la mémoire 45 (figure 15). Le circuit de décodage 68 applique un "1" sur le circuit OU correspondant à une couronne que l'on ne veut pas mettre en action. En d'autres termes, la table de vérité du circuit de décodage est la suivante:

| θ (Tolérances dimension- nelles) | Contenu binaire table No. 1 | Sortie circuit décodage | Couronnes en action |
|---|---|---|---|
| — | 000 | 1111 | — |
| 25μ | 001 | 0111 | C1 |
| 50μ | 010 | 0011 | C1, C2 |
| 75μ | 011 | 0001 | C1, C2, C3 |
| 100μ | 100 | 0000 | C1, C2, C3, C4 |

On voit que quand les sorties du circuit de décodage sont toutes égales à "1", aucune couronne n'est en action, cela revient à un transfert pur et simple de l'image, sans modification. Les sorties des circuits OU 64 à 67 ainsi que la sortie de la cellule correspondant au pixel central 55 sont reliées aux entrées du circuit ET 69. Le signal érodé $(I_{REF})_{min}$ selon un élément structurant déterminé par la valeur binaire affichée sur l'entrée du circuit de décodage 68, est disponible à la sortie du circuit ET 69.

Le bloc d'ajustement aux tolérances maximales (opération de dilatation) référencé 49 sur la figure 15, se déduit en fait très simplement du circuit montré sur la figure 17, si on se souvient que:

$$A \oplus B = (A^c \ominus B)^c$$

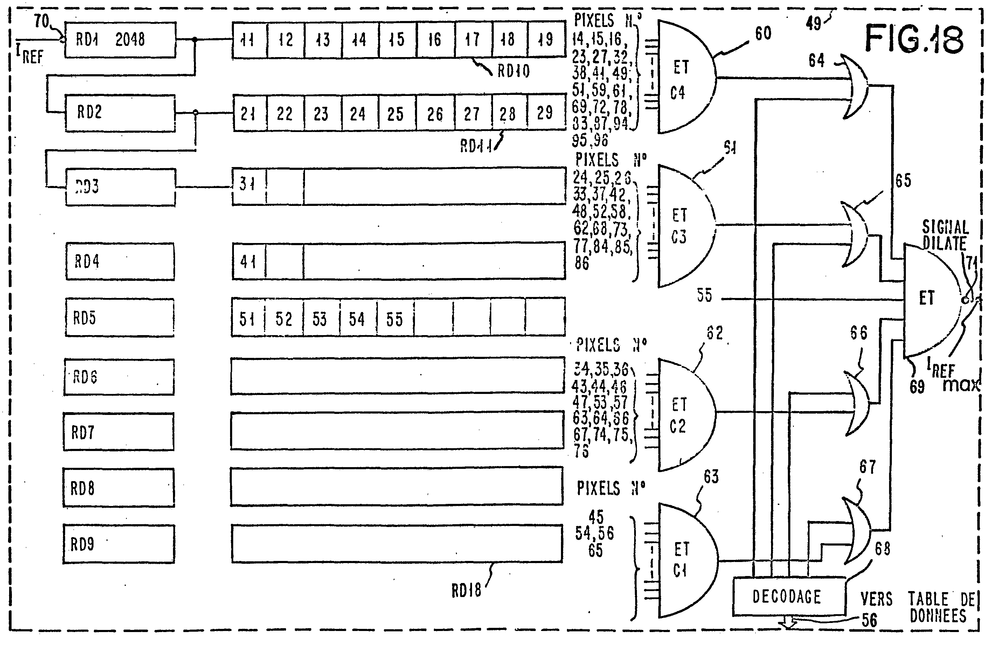

Le bloc 49 est montré sur la figure 18, il se déduit très simplement du bloc 48, en introduisant un inverseur 70 (pour obtenir $(I_{REF})^c$), puis en effectuant une complémentation du signal final par l'inverseur 71. En d'autres termes, il suffit d'ajouter deux inverseurs: un à l'entrée et un à la sortie du bloc 48 pour obtenir le bloc 49.

Tous les registres à décalage sont pilotés par l'horloge 27 comme cela est connu.

Le signal de référence $I_{REF}$ après érosion et dilatation est comparé avec $I_{EXA}$ dans un circuit de comparaison 51.

Sur la figure 19 on a représenté un exemple de circuit 51 susceptible de réaliser l'opération (SIGNAL A ou SIGNAL B) OU EXC. SIGNAL B entre les signaux d'entrée SIGNAL A et SIGNAL B, qui est l'opération de comparaison mentionnée comme l'une des opération de l'étape 5. Le circuit 51 comporte un circuit OU 72 qui reçoit d'une part le signal A préalablement inversé dans l'inverseur 73 et le signal B. Le signal résultant est de nouveau inversé dans l'inverseur 74. Le signal de sortie est donc:

$$(SIGNAL\ A\ OU\ SIGNAL\ B) = \overline{(SIGNAL\ A)}\ et\ \overline{(SIGNAL\ B)}$$

cette expression peut également s'écrire:

$$(SIGNAL\ A\ OU\ SIGNAL\ B)\ OU\ EXC.\ (SIGNAL\ B).$$

Si on applique au bloc 51, les signaux représentatifs de $(I_{REF})_{min}$ et $I_{EXA}$ on trouve le signal représentatif des défauts du genre "manque" en faisant

$$SIGNAL\ A = (I_{REF})_{min}\ et\ SIGNAL\ B = I_{EXA}.$$

Dans ce cas le bloc de comparaison 51 sera référencé 51A.

De façon similaire le signal représentatif des défauts du genre "extension" s'obtient en faisant

$$SIGNAL\ A = I_{EXA}\ et\ SIGNAL\ B = (I_{REF})_{max}$$

et le bloc de comparaison sera référencé 51B.

Après les opérations de comparaison les images de défauts du genre "manque" et du genre "extension" sont disponibles. Il s'agit maintenant d'analyser les défauts.

Pour la simplification de l'exposé, seul le bloc d'analyse 52A des défauts du genre manque sera décrit en détail.

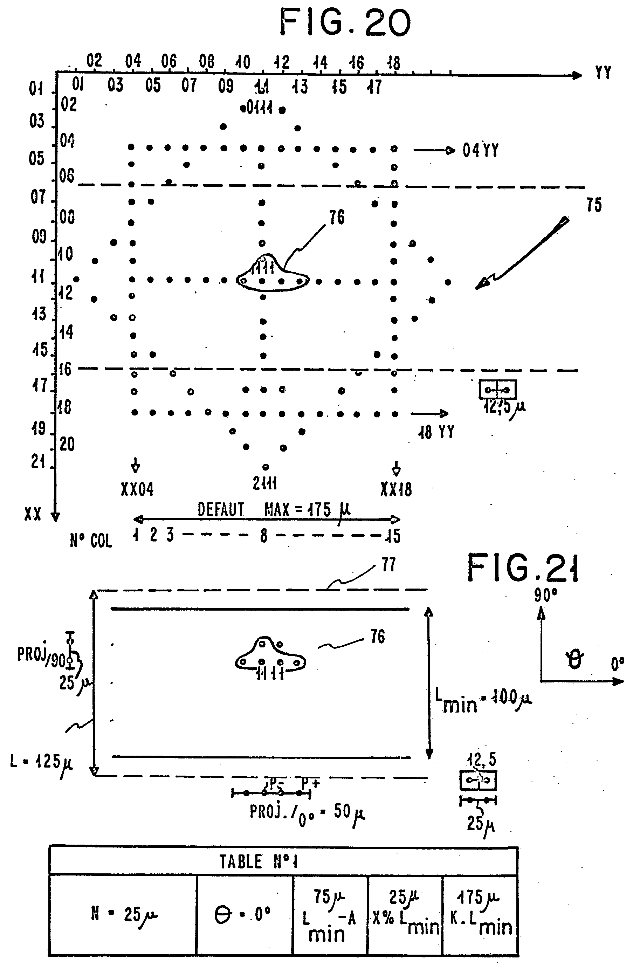

Sur la figure 20 on a représenté une fenêtre d'analyse 75 de 15×15 pixels qui présente quatre axes de symétrie (0, 45, 90 et 135°). La forme globale est celle d'une étoile à huit branches. Tous les pixels à l'intérieur de cette étoile sont pris en considération (tous ne sont pas représentés sur la figure 20). Les pixels sont référencés par leurs coordonnées en X et en Y comme cela apparaît clairement sur la figure. Le pixel central a donc pour coordonnées 1111. La taille et la forme de la fenêtre d'analyse sont fonction de l'application, notamment de la taille du défaut maximum admissible. Autour du pixel central 111 qui est par

16

**0 054 596**

définition le pixel en cours d'analyse, on a représenté un défaut quelconque qui porte la référence 76. Ce défaut 76 du genre "manque" se trouve par exemple sur un conducteur 77 de largeur nominale L=125 μ et de direction θ=0°C (voir la figure 21). Les projections horizontale et verticale de ce défaut sont 50 μ et 25 μ. Les projections se décomposent en deux éléments autour du pixel central: $P^-$ et $P^+$ par exemple pour la projection horizontale $P^-$=25 μ et $P^+$=25 μ. Le calcul des projections se fait à partir des photodiodes activées donc de carrés de 12,5 μ de côté, schématiquement représentés par des pixels. Le pixel central est considéré arbitrairement comme faisant partie de la projection $P^-$. En d'autres termes, il suffit de compter le nombre de pixels activés, selon les deux projections et de multiplier par l'intervalle de 12,5 μ pour connaître la valeur de ces projections. Le défaut 76 comprend quatre pixels selon la direction 0° et deux pixels selon la direction 90°, d'où les valeurs indiquées. Sur la figure 21 on a représenté également les données extraites de la table de données No. 1 relatives au carré qui contient le pixel central. Pour ce pixel, la table indique que la tolérance est N=25 μ (donnée qui a été utilisée lors de l'étape d'ajustement aux tolérances minimales dans le bloc 51A de la figure 15), que l'orientation du conducteur est θ=0° et que les critères de rejet sont $L_{min}-A>75$ μ, $X\%\ L_{min}>25$ μ et $k\ L_{min}>175$ μ. Toutes ces valeurs sont imposées par la valeur de la largeur nominale du conducteur 77 (L=125 μ). On rappelle que les critères de rejet sont calculés à partir de $L_{min}$, mais ils pourraient l'être aussi bien à partir de L. En rendant les critères de rejet plus sélectifs, on améliore la sécurité du présent procédé d'inspection.

La figure 22 représente schématiquement les différents circuits qui composent le bloc 52A d'analyse des défauts au regard des critères de rejet. Il a deux fonctions principales: calcul des projections du défaut selon les directions θ et θ+90°, et comparaison avec les critères de rejet qui correspondent à la taille maximale admissible du défaut.

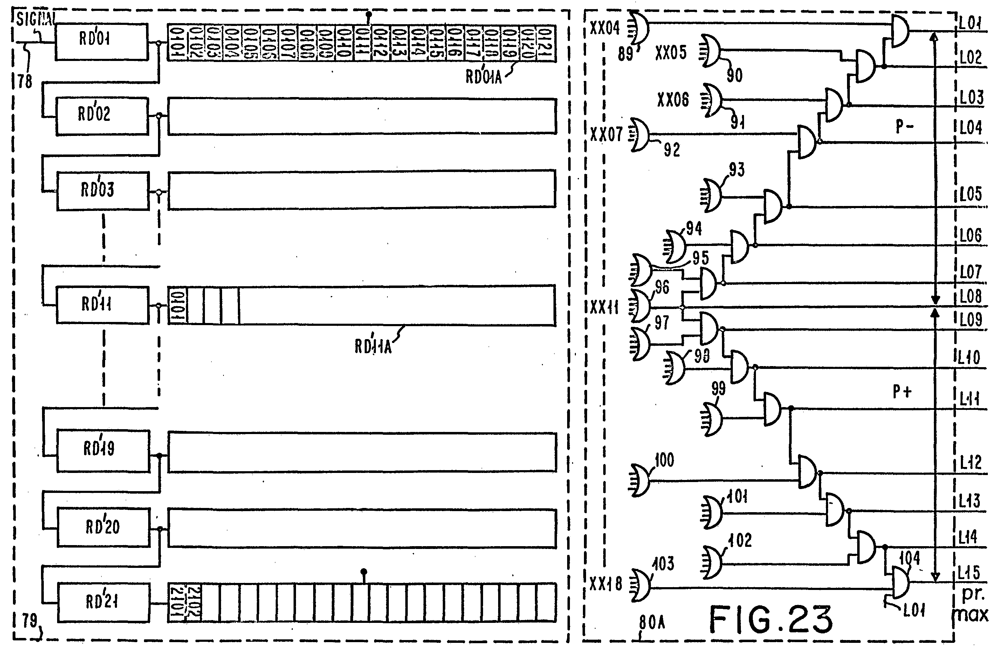

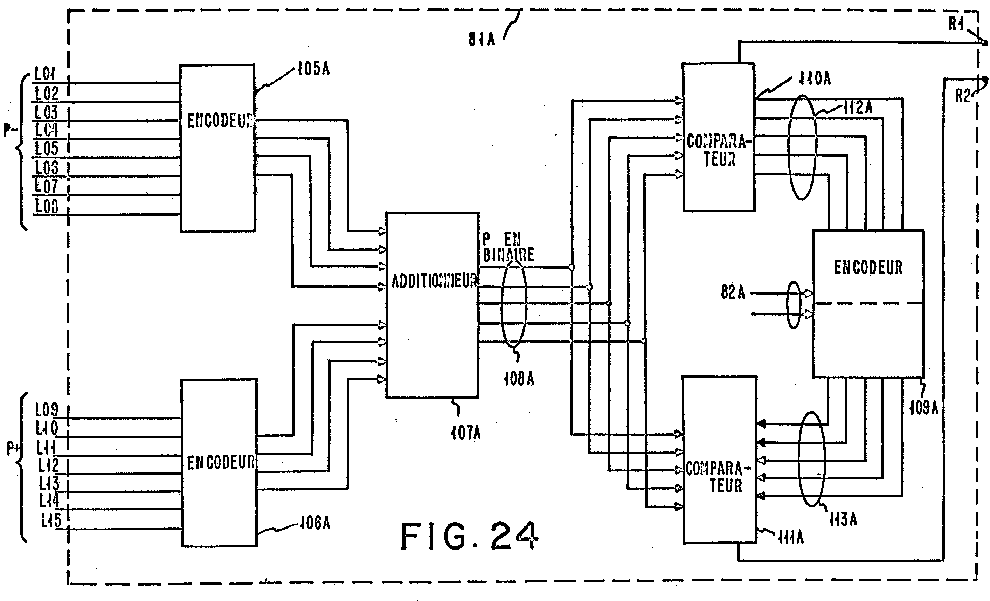

Le signal 78 qui arrive sur le bloc 52A est donc le signal représentatif de l'image des défauts du genre "manque". Un premier circuit 79 composé notamment de registres à décalage à sorties parallèles va permettre d'accéder à tout instant au contenu (0 ou 1) des cellules de ces registres correspondants aux pixels désirés de la fenêtre 75, distingués par leur coordonnée. Ce circuit 79 est décrit en détail sur la figure 23. A la sortie de ce circuit 79 sont disponibles tous les pixels (sous forme binaire) de la fenêtre d'analyse, donc correspondant aux positions de coordonnées 0111 à 2111. Dans les blocs 80 on calcule la longueur du défaut ou plus exactement ses projections dans les quatre directions, par exemple le circuit 80A calcule la projection du défaut dans la direction 0°. A la sortie de ce circuit la valeur binaire affichée sur les lignes L01 à L15 est représentative de la longueur du défaut. Ce circuit 80A est décrit en détail sur la figure 23. On se souvient que les critères de rejet comportent deux termes ($L_{min}-A$ et $X\%\ L_{min}$) pour la projection verticale et un terme ($k\ L_{min}$) pour la projection horizontale du défaut (voir la figure 21), le rôle des circuits 81 est donc, après décodage des deux directions en cause (par exemple 0° et 90°), de s'assurer que les dimensions du défaut selon ces deux directions sont acceptables. Les circuits 81 sont contrôlés à partir d'un démultiplexeur 82 qui reçoit ses informations de la mémoire 45 par le bus 57, selon une table de vérité qui sera décrite ci-après. Chaque circuit 81 comporte donc deux sorties. Le circuit 81A est décrit en détail sur la figure 24. Les informations disponibles sur les deux lignes de chaque circuit 81 sont représentatives du caractère acceptable ou non de la projection du défaut selon la direction en cause. Ces informations sont transmises à un multiplexeur 83 qui selon la valeur de θ sélectionne parmi les huit couples possibles, les deux couples qui correspondent à la direction du conducteur et sa direction perpendiculaire puisque les critères de rejet contiennent trois termes, on comprend que seules trois valeurs (1 projection horizontale et 2 projections verticales) sont utiles. A la sortie du multiplexeur 83 on trouve trois valeurs sur les trois lignes W1, W2 et W3.

Le circuit ET 84 s'assure que si la projection verticale du défaut est supérieure à $X\%\ L_{min}$ et que sa projection horizontale est supérieure à $k\ L_{min}$, le défaut doit conduire au rejet (W4 au niveau 1). La ligne W1 est haute (W1 au niveau 1) quand la projection verticale est supérieure à $L_{min}-A$. Les lignes W1, W4 et W5 sont reliées à un circuit OU 85, si une seule de ces trois lignes est haute, la ligne 53A est haute, le défaut est inacceptable et le module rejeté. La ligne W5 est issue des lignes L15, M15, U15 et V15 qui comme on le verra ci-après sont hautes dès lors qu'au moins une des deux projections selon les directions en cause est supérieure à la dimension de la fenêtre d'analyse (15 pixels). Le circuit OU 86 reçoit le couple de lignes L15 et M15, Le circuit OU 87 reçoit le couple U15 et V15, et le multiplexeur 88 contrôlé par la direction du conducteur θ sélectionne le bon couple.

Le fonctionnement du bloc 52A va être mieux compris à l'aide de la description détaillée des circuits montrés sur les figures 23 et 24. Sur la figure 23 on a représenté le bloc 79 qui sert à la mémorisation de la fenêtre d'analyse. Ce bloc comprend 21 registres à décalage de 2048 bits référencés RD01 à RD21, puisque la fenêtre d'analyse 75 se développe sur 21 lignes (entre les pixels 0111 et 2111). Ces registres à décalage s'alimentent en cascade. Chaque registre tel que RD01 est relié à un registre à décalage à 21 bits (correspondants aux 21 colonnes de la fenêtre d'analyse) référencé RD01A. Ce registre est du type à sortie parallèle, c'est-à-dire que le contenu de chaque cellule est accessible. Il contient tous les pixels de coordonnées 01YY avec YY variant de 01 à 21, c'est-à-dire tous les pixels de la première ligne dont on sait que seul le pixel 0111 est utile pour constituer la fenêtre d'analyse. On procède de la même façon pour tous les autres registres. Par exemple, le registre RD11A contient tous les pixels de la onzième ligne, c'est-à-dire les pixels 1101 à 1121, tous ces pixels sont utilisés au moins une fois pour constituer la fenêtre d'analyse.

Le défaut 76 des figures 20 et 21 est caractérisé en ce que les pixels portant les coordonnées 1011, 1110, 1111, 1112 et 1113 ont la valeur binaire 1.

17

Les circuits 80, ont pour objet de calculer les longueurs du défaut.

Les circuits 80A et 80B calculent respectivement les dimensions du défaut selon les directions 0 et 90°, c'est-à-dire les projections horizontales et verticales du défaut 76 choisi à titre d'exemple. Dès que le défaut 76 rentre entièrement dans la fenêtre d'analyse, les valeurs de ses projections exactes sont disponibles sur les lignes L01 à L15. Le circuit 80A comporte une série de 15 circuits OU référencés 89 à 103, munis de 15 entrées. La porte OU 89 correspond à tous les pixels de la première colonne de la fenêtre d'analyse 75 selon la direction 0°, c'est-à-dire les pixels référencés XX01 avec XX variant de 04 à 18, et ainsi de suite pour toutes les portes OU, la porte OU 103 faisant la sommation des pixels de la quinzième colonne c'est-à-dire les pixels XX18 avec XX variant de 04 à 18. Du point de vue cablage, ou comprend que les entrées de la porte OU 89 sont reliées aux sorties des cellules portant les numéros correspondants, par exemple le première entrée 0404 est reliée à la sortie de la quatrième cellule de RD04. On procède de même pour toutes les portes OU de 80A. La construction des circuits 80B, 80C et 80D s'en déduit aisément. Les sorties des portes OU sont reliées à des portes ET de la façon représentée sur la figure 23. Les sorties des portes ET sont référencées L01 à L15, l'état de ces sorties indique la longueur du défaut selon la direction considérée, par rapport à la ligne centrale L08 qui est représentative du pixel central analysé. Dans notre exemple, quand la fenêtre d'analyse 75 est centrée sur le pixel 1111 du défaut 76, seules quatre portes OU ont une sortie égale à 1, ce sont les portes 95, 96, 97 et 98 qui correspondent aux 7°, 8°, 9° et 10° colonnes de la fenêtre pour lesquels il y a au moins un pixel de valeur 1. On ne va donc trouver un 1 que sur les lignes L07, L08, L09 et L10. Cela veut dire que le défaut a une projection horizontale de quatre pas de 12,5 µ soit 50 µ qui se décompose en P⁻=25 µ et P⁺=25 µ de part et d'autre du pixel central analysé (voir figure 21).

La ligne L08 est au niveau 1 dès lors que le pixel central analysé est un pixel correspondant à un défaut. Le nombre de lignes qui sont au niveau haut de part et d'autre de la ligne L08 permet la détermination immédiate de la projection du défaut (en multiple de 12,5 µ). La rupture du défaut impose des "0" sur toutes les lignes à compter de la rupture. Par exemple le défaut 76 ne s'étend pas jusqu'à la sixième colonne, la porte OU 94 qui correspond aux pixels de cette colonne ne reçoit que des 0 sur ses entrées et affiche donc un 0 sur la porte ET qui la suit, le 0 est transmis en cascade sur toutes les portes ET, de telle sorte que les lignes L06 à L01 sont au niveau bas (0).

Une porte ET 104 joue un rôle particulier. La ligne L01 lui est également appliquée. En d'autres termes L15 sera au niveau 1 lorsque le défaut sera plus grand ou égal à la dimension de la fenêtre d'analyse (15 pixels), dans ce cas la ligne L15 indique que la projection du défaut est plus grande que la fenêtre d'analyse et que le module doit être rejeté.

Les circuits 80B, 80C et 80D fonctionnent de façon identique, et leurs sorties sont référencées respectivement M01 à M15, N01 à N15 et Q01 à Q15.

Les circuits 80A à 80D fonctionnent en permanence et les projections selon les quatre directions sont disponibles à tout instant. Par exemple, lorsque la fenêtre d'analyse est centrée sur le pixel central 1111, le circuit 80A qui mesure la projection horizontale (selon la direction 0°) du défaut 76 fournit la valeur 50 µ, le circuit 80B qui mesure la projection verticale (selon la direction 90°) fournit la valeur 25 µ. Les projections du défaut selon les directions 45° et 135° sont respectivement disponibles sur les lignes N01 à N15 et Q01 à Q15, mais sont sans intérêt dans ce cas, puisque la direction θ du conducteur 77 est 0°.

Les projections sont alors quantifiées, c'est le rôle des encodeurs 105A et 106A. En sortie on a donc la valeur binaire correspondant à la valeur de la projection. Les encodeurs peuvent être des mémoires EPROM du type MM 2708. Les projections P⁻ et P⁺ sont appliquées sur les entrées "adresses" et la valeur binaire est disponible sur les sorties "données".

La fonction de transfert des encodeurs 105A et 106A est la suivante:

| Lignes L | 01 15 | 02 14 | 03 13 | 04 12 | 05 11 | 06 10 | 07 09 | 08 08 | données |
|---|---|---|---|---|---|---|---|---|---|
| | 0 | 0 | 0 | 0 | 0 | 0 | 0 | 0 | 0000 |
| | 0 | 0 | 0 | 0 | 0 | 0 | 0 | 1 | 0001 |
| | 0 | 0 | 0 | 0 | 0 | 0 | 1 | 1 | 0010 |
| | 0 | 0 | 0 | 0 | 0 | 1 | 1 | 1 | 0011 |
| | 0 | 0 | 0 | 0 | 1 | 1 | 1 | 1 | 0100 |
| | 0 | 0 | 0 | 1 | 1 | 1 | 1 | 1 | 0101 |
| | 0 | 0 | 1 | 1 | 1 | 1 | 1 | 1 | 0110 |
| | 0 | 1 | 1 | 1 | 1 | 1 | 1 | 1 | 0111 |
| | 1 | 1 | 1 | 1 | 1 | 1 | 1 | 1 | 1000 |

Le pixel central faisant partie comme on l'a vu de $P^-$, la valeur maximale de $P^+$ est 0111 alors que la valeur maximale de $P^-$ est 1000.

La valeur binaire de la projection total $P=P^-+P^+$ est réalisée par l'additionneur binaire 107A, et elle est disponible sur le bus 108A.

La projection horizontale du défaut 76 est telle que $P^-=25$ μ et $P^+=25$ μ, ou encore $L07=L08=L09=L10=1$, toutes les autres lignes étant à 0.

Le premier encodeur 105A qui correspond à $P^-$ fournit la valeur binaire 0010 tandis que l'encodeur 106A qui correspond à $P^+$ fournit également la valeur binaire 0010. A la sortie de l'additionneur 107A, la projection horizontale du défaut 76 est représentée par la valeur binaire $0010+0010=0100$.

En sortie d'additionneur la valeur binaire 0000 représente l'absence de défaut, la valeur 0001, un défaut réduit à un pixel, la valeur 1111 correspond à un défaut de taille maximale $P^-+P^+=15$ pas de 12,5 μ=187,5 μ, qui englobe bien la valeur 175 μ qui est un des critères de rejet.

On a vu plus haut qu'avec les critères de rejet choisis (voir notamment la figure 21 qui montre les critères de rejet relatifs au défaut 76 du conducteur 77), que pour chaque projection il y a au maximum deux seuils à analyser. Dans le cas précis de la figure 21, il faut s'assurer que la projection verticale du défaut 76 (mesurée égale à 25 μ) est bien inférieure ou égale d'une part à X% $L_{min}=0,25.100$ μ=25 μ et à $L_{min}-A=100-25$ μ=75 μ. On se souvient qu'un défaut présentant une projection supérieure à 0,25 L peut être néan-moins acceptable si sa projection perpendiculaire est inférieure à 1,75 $L_{min}$.

On a donc au plus deux seuils à analyser. Par exemple avec l'exemple choisi, le circuit 81A qui analyse la projection horizontale doit la comparer au seuil k $L_{min}=175$ μ, tandis que le circuit 81B qui analyse la projection verticale doit comparer cette dernière aux seuils X% $L_{min}=25$ μ et $L_{min}-A=75$ μ. Dans le premier cas les données sont fournies à partir du bus 82A (élaborées dans le démultiplexeur 82), au circuit double encodeur 109A, qui affiche les critères de rejet sous forme binaire sur les deux comparateurs 110A et 111A. Par exemple, pour le circuit 81A, l'encodeur affiche 1,75 $L_{min}=175$ μ (valeur binaire 1110) sur le comparateur 110 par le bus 112A, ce comparateur reçoit par ailleurs la projection horizontale P du défaut 76 soit 50 μ (valeur binaire 1000), la projection P étant inférieure au critère de rejet, (défaut acceptable), la sortie R1 de l'additionneur est au niveau bas (0). Au cas où la projection P serait supérieure à la valeur définie par le critère de rejet (défaut inacceptable), la sortie R1 aurait la valeur binaire 1. Dans le cas du circuit 81A, un seul critère de rejet existe, aussi l'encodeur 109A affiche 1111 sur le comparateur 111A par le bus 113A qui reçoit également le projection P (1000) sur ses autres entrées, la sortie R2 est donc au niveau "0".

Le circuit 81B qui analyse la projection verticale du défaut 76, a donc deux critères de rejet: $L_{min}-A=75$ μ et X% $L=25$ μ, ces valeurs sont affichées en binaire sur l'encodeur 109B à partir du bus 82B, de telle sorte que le comparateur 110B effectuera la comparaison entre la projection verticale du défaut P=25 μ et X% $L_{min}=25$ μ et le comparateur 111B effectuera de même la comparaison entre P=25 μ et $L_{min}-A=75$ μ. Le défaut 76 étant acceptable après cette double comparaison les sorties T1 (qui correspond au critère X% $L_{min}$) et T2 (qui correspond au critère $L_{min}-A$) sont également au niveau 0.

Les circuits 81C et 81D qui correspondent à des projections selon des directions non prises en considération, ont leurs sorties respectives U1, U2 et V1, V2 forcées au niveau 0 à partir des commandes bus 82C et 82D en provenance du démultiplexeur 82, de toute façon ces sorties ne seront pas prises en considération (dans l'exemple du défaut 76) par le multiplexeur 83, comme cela sera expliqué ci-après. Ce démultiplexeur est représenté sur la figure 22. Il est commandé à partir du bus 57 qui contient les données θ, $L_{min}-A$, X% $L_{min}$, k $L_{min}$. Selon la valeur de θ, on aiguille les critères de rejet vers les circuits appropriés selon la table de transfert suivante:

| θ | | Critères affichés sur les bus | | | | | | | |
|---|---|---|---|---|---|---|---|---|---|
| | | 82A | | 82B | | 82C | | 82D | |
| en degrés | en valeur binaire | R1 | R2 | T1 | T2 | U1 | U2 | V1 | V2 |
| 0° | 00 | k$L_{min}$ | | X%$L_{min}$ | $L_{min}-A$ | | | | |
| 90° | 01 | X%$L_{min}$, | $L_{min}-A$ | k$L_{min}$ | | | | | |
| 45° | 11 | | | | | k$L_{min}$ | | X%$L_{min}$, | $L_{min}-A$ |
| 135° | 11 | | | | | x%$L_{min}$, | $L_{min}-A$ | k$L_{min}$ | |

On rappelle que le défaut 76 se trouve dans un carré pour lequel $L_{min}=100$ μ, A=25 μ, X=0,25 et k=1,75 (voir la figure 21). Toutes les sorties R1, R2, T1, T2, U1, U2, V1, V2 sont connectées à un multiplexeur 83, qui selon la valeur de l'angle θ qui lui est appliqué sélectionnera les sorties appropriées selon la table suivante qui montre les correspondances

# 0 054 596

| θ | W1 | W2 | W3 |
|---|----|----|----|
| 0 | T2 | T1 | R1 |
| 90 | R2 | R1 | T1 |
| 45 | V2 | V1 | U1 |
| 135 | U2 | U1 | V1 |

Par exemple pour la défaut 76, on avait $\theta=0°$, R1 correspondait à la comparaison avec le critère de rejet 1,75 $L_{min}$, tandis que T1 et T2 correspondaient aux critères de rejet 0,25 $L_{min}$ et $L_{min}-25$. On a vu que le défaut 76 était acceptable donc R1=0, T1=0, T2=0, les lignes W1, W2, W3 sont au niveau bas, la sortie W4 de la porte 84 est au niveau bas, ainsi que la ligne W1, si la sortie W5 est également au niveau bas, la porte OU affiche un 0 à sa sortie sur la ligne 53A, on considère que le défaut mesuré à partir du pixel analysé est bon.

Pour qu'un défaut soit considéré comme inacceptable, il suffit que la ligne W1 soit au niveau 1 (cela signifie que la projection verticale du défaut est supérieure au critère de rejet $L_{min}-A$) *ou* que la ligne W4 soit au niveau 1 (cela signifie que la projection verticale du défaut est supérieure à $kL_{min}$ *et* que sa projection horizontale est supérieure à $KL_{min}$) ou enfin que W5 soit au niveau 1. La ligne W5 résulte à travers le multiplexeur 88 des lignes L15, M15, N15 et Q15 dont on sait qu'elles sont à un niveau haut dès que le défaut atteint, selon la direction en cause, la taille de la fenêtre d'analyse. Le multiplexeur sélectionne selon la valeur θ, le couple utile, par exemple dans le cas du défaut 76, si $\theta=0°$, il sélectionne la sortie de la porte OU 86. Si L15 (ou M15) est au niveau haut cela signifie que la projection horizontale (ou verticale) atteint au moins 15 pixels et que par hypothèse on considère qu'un tel défaut doit conduire au rejet du module.

Le bloc d'analyse des défauts 52B est identique dans sa structure et son fonctionnement au bloc 52A. Seulement les critères de rejet contenus dans la table de données No. 2, correspondent comme on l'a vu à l'espace interconducteur et à la direction θ' de cet espace.

Les lignes 53A et 53B sont connectées à une porte OU, qui fait la réunion entre les informations issues des blocs d'analyse de défauts 52A et 52B, l'information finale est traitée par le calculateur.

## Revendications

1. Procédé d'inspection et de tri automatique d'objets présentant des configurations ayant des tolérances dimensionnelles et des critères de rejet variables selon l'endroit inspecté de l'objet, du genre comportant la comparaison de l'image d'un objet de référence et de l'image d'un objet à examiner, ce dernier étant susceptible de présenter des défauts géométriques par rapport à l'objet de référence, caractérisé en ce qu'il comporte les étapes suivantes:

— élaboration des images électroniques binaires $I_{REF}$ et $I_{EXA}$ de l'objet de référence et de l'objet à examiner,
— définition pour chaque point image, nommé ci-après pixel, d'un élément structurant B dont la taille est susceptible de varier pour chaque pixel en fonction des données prédéterminées et ajustement de $I_{REF}$ aux tolérances dimensionnelles maximales et minimales, par dilatation et érosion de cette image par l'élément structurant B, ce qui donne $(I_{REF})_{max}$ et $(I_{REF})_{max}$ et $(I_{REF})_{min}$,
— formation des images des défauts du genre "extension" et du genre "manque" en réalisant respectivement les opérations logiques $[(I_{REF})_{max}$ OU $I_{EXA}]$ OU EXC. $(I_{REF})_{max}$ et $[(I_{REF})_{min}$ OU $I_{EXA}]$ OU EXC. $I_{EXA}$,
— mesure de la taille des défauts sur les images de défauts et comparaison avec des critères de rejet qui définissent pour chaque pixel les dimensions de défauts acceptables selon des données prédéterminées, et
— tri et sélection des objets sans défaut ou présentant des défauts acceptables au vu desdits critères de rejet.

2. Procédé d'inspection et de tri selon la revendication 1 caractérisé en ce que l'étape d'élaboration des images $I_{REF}$ et $I_{EXA}$ comporte les étapes suivantes:
saisie d'images $I_{ref}$ et $I_{exa}$ de l'objet de référence et de l'objet à examiner sous forme analogique en noir et blanc avec tous les niveaux de gris,
échantillonnage des images selon une trame déterminée choisie dans le groupe comprenant par exemple, la trame hexagonale ou la trame carrée,
quantification de l'image pour ne garder qu'un nombre $2^N$ de niveaux de gris avec $2 \leq N \leq 6$, et
seuillage des images pour obtenir lesdites images binaires électroniques.

3. Procédé d'inspection et de tri selon la revendication 2, caractérisé en ce que l'étape de seuillage comporte la détermination du seuil des images $I_{ref}$ et $I_{exa}$, qui est effectuée à partir de l'histogramme des intensités des pixels.

20

4. Procédé d'inspection et de tri selon la revendication 3 caractérisé en ce que la détermination du seuil s'effectue à l'aide d'un programme informatique.

5. Procédé d'inspection et de tri selon la revendication 1 caractérisé en ce que l'étape d'élaboration des images électroniques binaires $I_{REF}$ et $I_{EXA}$ comporte les étapes suivantes:

saisie d'une image $I_{exa}$ de l'objet à examiner sous forme analogique en noir et blanc avec tous les niveaux de gris,

échantillonnage de cette image selon une trame déterminée choisie dans le groupe comprenant par exemple la trame héxagonale ou la trame carrée,

quantification de l'image pour ne garder qu'une nombre $2^N$ de niveaux de gris avec $2 \leq N \leq 6$,

seuillage de l'image pour obtenir $I_{EXA}$ et

élaboration directe de $I_{REF}$ soit à partir d'un générateur de configuration numérique soit à partir d'une banque de données.

6. Procédé d'inspection et de tri selon l'une des revendications ci-dessus, caractérisé en ce qu'il comporte en outre l'étape de l'élimination du bruit des images $I_{REF}$ et $I_{EXA}$ effectuée avant l'étape de l'ajustement aux tolérances dimensionnelles et consistant soit dans une opération d'ouverture, soit dans une opération de fermeture, soit dans une combinaison des deux, la taille de l'érosion étant inférieure à la taille du plus petit défaut que l'on doit détecter.

7. Procédé d'inspection et de tri selon la revendication 4, 5 ou 6 caractérisé en ce qu'il comporte en outre une étape de cadrage des images électroniques $I_{REF}$ et $I_{EXA}$ correspondant au cadrage optique des images $I_{ref}$ et $I_{exa}$.

8. Procédé d'inspection et de tri selon l'une des revendications ci-dessus, caractérisé en ce que l'élément structurant a la forme approximative d'un cercle de diamètre variable.

9. Procédé d'inspection et de tri selon la revendication 8 caractérisé en ce que l'élément structurant est composé par une pluralité de couronnes concentriques, se développant à partir du pixel central qui est le pixel analysé, ces couronnes se déduisant l'une de l'autre par deux pas ou intervalles entre pixels.

10. Procédé d'inspection et de tri selon l'une des revendications ci-dessus, caractérisé en ce que la taille de chaque défaut est évaluée par le calcul des projections horizontale et verticale sur au moins un couple d'axes perpendiculaires.

11. Procédé d'inspection et de tri selon la revendication 10 caractérisé en ce que la direction de l'une des axes perpendiculaires correspond à la direction principale $\theta$ du motif de la configuration qui contient le défaut.

12. Procédé d'inspection et de tri selon la revendication 11 caractérisé en ce que les critères de rejet sont déduits des dimensions du motif et de sa direction sous la forme de termes comparables avec lesdites projections.

13. Procédé d'inspection et de tri selon l'une des revendications ci-dessus, caractérisé en ce que lesdites données prédéterminées sont rangées dans deux tables de données No. 1 et No. 2 respectivement pour les défauts du genre "manque" et du genre "extension".

14. Procédé d'inspection et de tri selon la revendication 13 caractérisé en ce que pour chaque pixel, les données correspondantes comprennent la tolérance dimensionnelle N, la direction du motif $\theta$, et les critères de rejet qui définissent une ou plusieurs fenêtres d'analyse.

15. Procédé d'inspection et de tri selon la revendication 12 caractérisé en ce que les critères de rejet, la tolérance dimensionnelle, et la direction $\theta$ sont communs pour tous les pixels d'une même région.

16. Procédé d'inspection et de tri selon la revendication 15 caractérisé en ce que les critères de rejet, la tolérance dimensionnelle et la direction $\theta$ sont générés automatiquement pour chaque région par un calculateur après balayage de $I_{REF}$ selon les directions possibles des motifs de la configuration, à l'aide d'un programme informatique.

17. Appareil pour l'inspection et le tri automatique d'objets présentant des configurations ayant des tolérances dimensionnelles et des critères de rejet variables selon l'endroit inspecté de l'objet, du genre comportant des moyens de saisie (21, 24) de l'image d'un objet de référence (22) et de l'image d'un objet à examiner (25), et des moyens de comparaison desdites images, l'objet à examiner étant susceptible de présenter des défauts géométriques par rapport à l'objet de référence, caractérisé en ce qu'il comporte:

— des moyens d'élaboration (37, 40, 45) des images électroniques binaires $I_{REF}$ et $I_{EXA}$ de l'objet de référence et de l'objet à examiner,

— des moyens de traitement (43) qui comprennent des moyens d'ajustement (48, 49) de $I_{REF}$ aux tolérances maximales et minimales par dilatation et érosion par un élément structurant B dont la taille est susceptible de varier pour chaque point image ci-après nommé pixel, en fonction de données prédéterminées, des circuits de comparaison (51A, 51B) pour la formation des images de défauts du genre extension et du genre manque en réalisant respectivement les opérations logiques

$$[(I_{REF})_{max} \text{ OU } I_{EXA}] \text{ OU EXC } (I_{REF})_{max} \text{ et}$$

$$[(I_{REF})_{min} \text{ OU } I_{EXA}] \text{ OU EXC. } I_{EXA} \text{ et}$$

**0 054 596**

— des moyens d'analyse (52A, 52B) des défauts qui comprennent des moyens de mesure (80A, 80B) de la taille des défauts et des moyens de comparaison (81A, 81B) avec des critères de rejet qui définissent pour chaque pixel les dimensions de défaut acceptables, selon des données prédéterminées, et

— des moyens de tri et de sélection des objets "bons".

18. Appareil selon la revendication 17 caractérisé en ce qu'il comprend en outre:

des moyens de synchronisation et d'adressage (27, 47) qui à chaque pixel analysé, extraient d'une mémoire (45) où elles ont été préalablement chargées, lesdites données prédéterminées.

19. Appareil selon la revendication 18 caractérisé en ce que les moyens de saisie (21, 24) sont choisis dans le groupe comprenant, les microscopes électroniques, les caméras de télévision, les réseaux de photodiodes et les réseaux à charges couplées.

20. Appareil selon la revendication 18 ou 19 caractérisé en ce que lesdits moyens d'élaboration des images électroniques $I_{REF}$ et $I_{EXA}$ comportent une unité de détection de seuil et de seuillage (37, 40) pour seuiller au moins $I_{EXA}$.

21. Appareil selon la revendication 18 ou 19 caractérisé en ce que $I_{REF}$ est stockée dans une mémoire tampon.

22. Appareil selon la revendication 18, 19, 20 ou 21, caractérisé en ce qu'il comporte en outre des moyens de calcul (42) pour assurer le recadrage des images électroniques $I_{REF}$ et $I_{EXA}$.

23. Appareil selon l'une des revendications 17 à 22 caractérisé en ce que les moyens d'ajustement comprennent un circuit d'ajustement de $I_{REF}$ aux tolérances dimensionnelles minimales à l'aide d'un élément structurant de forme circulaire et de taille variable constitué par une pluralité de couronnes concentriques (C1—C4), ledit circuit d'ajustement aux tolérances dimensionnelles minimales comportant:

— des moyens de mémorisation (RD1—RD18) dans des cellules de mémoire de tous les pixels de $I_{REF}$ constituant ledit élément structurant,

— une pluralité de portes ET (60—63) assurant respectivement la formation de chacune desdites couronnes, les entrées de chaque porte ET étant constituées par le contenu des cellules correspondant aux pixels constitutifs de la couronne en cause,

— des moyens de décodage (64—68) pour sélecter le nombre et le rang des couronnes désirées, et

— une porte ET (69) pour assurer l'intégration desdites couronnes sélectées, de sorte qu'à la sortie de cette porte le signal $(I_{REF})_{min}$ soit obtenu.

24. Appareil selon la revendication 23 caractérisé en ce que:

lesdits moyens de mémorisation comportent d'une part n registres à décalage (RD1 à RD9) dont le nombre de cellules correspond au nombre de pixels de chaque ligne de $I_{REF}$, et n correspond au nombre de lignes de l'élément structurant, et d'autre part n registres à décalage (RD10 à RD18) composés de cellules à sorties parallèles dont le nombre de cellules correspond au nombre de colonnes de l'élément structurant.

25. Appareil selon une des revendication 17 à 24 caractérisé en ce que les moyens d'ajustement comprennent un circuit d'ajustement de $I_{REF}$ aux tolérances dimensionnelles maximales à l'aide d'un élément structurant de forme circulaire et de taille variable constitué par une pluralité de couronnes concentriques (C1—C4), ledit circuit d'ajustement aux tolérances dimensionnelles maximales comportant:

— des moyens de mémorisation (RD1—RD18) dans des cellules de mémoire de tous les pixels de $(I_{REF})^c$ constituant ledit élément structurant,

— une pluralité de portes ET (60—63) assurant respectivement la formation de chacune desdites couronnes, les entrées de chaque porte ET étant constituées par le contenu des cellules correspondant aux pixels constitutifs de la couronne en cause,

— des moyens de décodage (64—68) pour sélecter le nombre et le rang des couronnes désirées, et

— une porte ET (69) suivie d'un circuit inverseur (71) pour assurer l'intégration desdites couronnes sélectées, de sorte qu'à la sortie de cette porte le signal $(I_{REF})_{max}$ soit obtenu,

— un autre circuit inverseur (70) à l'entrée des moyens de mémorisation.

**Patentansprüche**

1. Verfahren fuer die Inspektion und die automatische Sortierung von Objekten unter Anwendung von Konfigurationen mit dimensionellen Toleranzen und von platzabhaengigen Kriterien fuer die Verwerfung des inspektierten Objekts, wie der Vergleich der Abbildung eines Referenzobjekts mit dem Bild des inspektierten Objekts, wobei das letztere geometrische Fehler im Vergleich zu dem Referenzobjekt aufweisen kann, dadurch gekennzeichnet, dass dieses Verfahren die folgenden Schritte aufweist:

— Herstellung von elektronischen binaeren Abbildungen $I_{REF}$ und $I_{EXA}$ des Referenzobjekts und des inspektierten Objekts,

— Bestimmung eines Konstruktionselement B fuer jeden Bildpunkt, im folgenden als Pixel bezeichnet, wo die Groesse dieses Konstruktionselement bei jedem Pixel in Abhaengigkeit von vorbestimmten Daten veraenderbar ist, und Einstellung von $I_{REF}$ auf die maximalen und minimalen dimensionellen Toleranzen

22

durch Dehnung und Erosion dieser Abbildung mit Hilfe des Konstruktionsobjekts B, was zu $(I_{REF})_{max}$ und $(I_{REF})_{min}$, fuehrt;

— Herstellung der Fehlerabbildungen, z.B. des Typs "Ausdehnung" und "Fehlen" durch entsprechende Ausfuehrung der logischen Operationen

$$[(I_{REF})_{max} \text{ ODER } I_{EXA}] \text{ ODER EXC. } (I_{REF})_{max} \text{ und}$$

$$[(I_{REF})_{min} \text{ ODER } I_{EXA}] \text{ ODER EXC. } I_{EXA};$$

— Messung der Groesse der in den Fehlerabbildungen dargestellten Fehler und Vergleich mit den Verwerfungskriterien, die bei jedem Pixel festlegen, welche Fehlerdimensionen in Abhaengigkeit von den vorbestimmten Daten annehmbar sind;

— Sortierung und Auswahl der fehlerfreien Objekte oder der mit Ruecksicht auf die Verwerfungskriteren annehmbaren Objekte.

2. Verfahren fuer die Inspektion und die Sortierung gemaess Anspruch 1, dadurch gekennzeichnet, dass der Schritt zur Herstellung der Abbildungen $I_{REF}$ und $I_{EXA}$ folgende Schritte aufweist:

— Erfassung von Abbildungen des Referenzobjekts und des inspektierten Objekts $I_{ref}$ und $I_{exa}$ in einer analogischen Schwarz-Weiss-Form einschliesslich der gesamten Graufarbtoene;

— Probenahme von den Abbildungen in Abhaengigkeit von einem bestimmten in einer aus einem sechsseitigen oder quadratischen Rahmen bestehenden Gruppe ausgewaehlten Rahmen;

— Quantifizierung der Abbildung, so dass eine einzige Zahl $2^N$ von Graufarbtoenen mit $2 \leq N \leq 6$ sich ergibt; und

— Schwellwert-Funktion fuer die Abbildungen zur Entstehung der elektronischen binaeren Abbildungen.

3. Verfahren fuer die Inspektion und die Sortierung gemaess Anspruch 2, dadurch gekennzeichnet, dass der Schritt der Schwellwert-Funktion die Festlegung des Schwellwerts fuer die Abbildungen $I_{ref}$ und $I_{exa}$, aufweist, was mittels des Histogramms der Pixel-Dichten ausgefuehrt ist.

4. Verfahren fuer die Inspektion und die Sortierung gemaess Anspruch 3, dadurch gekennzeichnet, dass die Festlegung des Schwellwerts mit Hilfe eines Datenverarbeitung-Programms ermittelt ist.

5. Verfahren fuer die Inspektion und die Sortierung gemaess Anspruch 1, dadurch gekennzeichnet, dass der Schritt zur Herstellung von den elektronischen binaeren Bilder $I_{REF}$ und $I_{EXA}$ folgende Schritte aufweist:

— Erfassung einer Abbildung $I_{exa}$ des zu inspektierendes Objekts in einer analogischen Schwarz-Weiss-Form einschliesslich der gesamten Graufarbtoene;

— Probenahme dieser Abbildung in Abhaengigkeit von einem bestimmten in der z.B. aus dem sechsseitigen und dem quadratischen Rahmen bestehenden Gruppe ausgewaehlten Rahmen;

— Quantifizierung der Abbildung, so dass nur eine Zahl $2^N$ von Graufarbtoenen mit $2 \leq N \leq 6$ sich ergibt;

— Schwellwertfunktion der Abbildung zur Festlegung von $I_{EXA}$ und;

— unmittelbare Herstellung von $I_{REF}$ mittels entweder eines Generators von numerischen Konfigurationen oder einer Datenbank.

6. Verfahren fuer die Inspektion und die Sortierung gemaess einem der obengenannten Ansprueche, dadurch gekennzeichnet, dass es ausserdem den Schritt zur Beseitigung des bei den Abbildungen $I_{REF}$ und $I_{EXA}$ erzeugten Geraeuesches aufweist, wobei dieser Schritt vor dem Schritt zur Einstellung auf den dimensionellen Toleranzen auftritt, und entweder in einem Einschalt- oder Ausschaltvorgang oder in einer Kombination von beiden Vorgaengen besteht, wobei die Groesse der Erosion kleiner als die des kleinsten abzutastenden Fehlers ist.

7. Verfahren fuer die Inspektion und die Sortierung gemaess Anspruch 4, 5 oder 6, dadurch gekennzeichnet, dass es ausserdem einen Schritt zur Pruefung der Positionierung der elektronischen Abbildungen $I_{REF}$ und $I_{EXA}$ in Uebereinstimmung mit der optischen Positionierung der Abbildungen $I_{ref}$ und $I_{exa}$.

8. Verfahren fuer die Inspektion und die Sortierung gemaess einem der obengenannten Anspruech, dadurch gekennzeichnet, dass das Konstruktionselement ungefaehr die Form eines Kreises mit einem veraenderkichen Durchmesser hat.

9. Verfahren fuer die Inspektion und die Sortierung gemaess Anspruch 8, dadurch gekennzeichnet, dass das Konstruktionselement aus einer Vielzahl von konzentrischen Kraenzen besteht, die sich ab dem zentralen Pixel, das heisst der ausgewertete Pixel, entwikeln lassen, wobei sich diese Kraenze in einem Abstand von jeweils zwei Pixel-Inkrementen gegeneinander befinden.

10. Verfahren fuer die Inspektion und die Sortierung gemaess einem der obengenannten Ansprueche, dadurch gekennzeichnet, dass die Groesse jedes Fehlers von der Berechnung der horizontalen und vertikalen Projektionen auf mindestens einem Paar von senkrechten Achsen hergeleitet werden kann.

11. Verfahren fuer die Inspektion und die Sortierung gemaess Anspruch 10, dadurch gekennzeichnet, dass die Richtung einer dieser senkrechten Achsen der Hauptrichtung θ des Musters der fehlerhaften Konfiguration enstpricht.

12. Verfahren fuer die Inspektion und die Sortierung gemaess Anspruch 11, dadurch gekennzeichnet, dass die Verwerfungskriterien von den Dimensionen des Musters und seiner Richtung in den gleichen Bedingungen wie bei den Projektionen hergeleitet werden koennen.

13. Verfahren fuer die Inspektion und die Sortierung gemaess einem der obengenannten Ansprueche, dadurch gekennzeichnet, dass die vorbestimmten Daten in zwei Datentabellen Nummer 1 und Nummer 2 bezueglich des jeweiligen Typs "Fehlen" und "Ausdehnung" untergeteilt sind.

14. Verfahren fuer die Inspektion und die Sortierung gemaess Anspruch 13, dadurch gekennzeichnet, dass bei jedem Pixel die entsprechenden Daten die dimensionnelle Toleranz N, die Richtung des Musters θ und die Verwerfungskriterien aufweisen, die ein oder mehrere Analysis-Fenster definieren.

15. Verfahren fuer die Inspektion und die Sortierung gemaess Anspruch 12, dadurch gekennzeichnet, dass jeder Pixel mit allen anderen in dem gleichen Bereich vorliegenden Pixel die Verwerfungskriterien, die dimensionelle Toleranz und die Richtung θ gemeinsam hat.

16. Verfahren fuer die Inspektion und die Sortierung gemaess Anspruch 15, dadurch gekennzeichnet, dass die Verwerfungskriterien, die dimensionelle Toleranz und die Richtung θ fuer jeden Bereich von einem Rechner mittels einem Programm automatisch erzeugt sind, nachher $I_{REF}$ in allen moeglichen Richtungen der Konfigurationsmuster abgetastet worden ist.

17. Anlage fuer die Inspektion und die automatische Sortierung von Objekten, unter Anwendung von Konfigurationen mit dimensionellen Toleranzen und von platzabhaengigen Kriterien fuer die Verwerfung des inspektierten Objekts, wo Mittel (21, 24) zur Erfassung der Abbildung eines Referenzobjekts (22) und des Bildes eines zu inspektierenden Objekts (25) und Mittel zum Vergleich von den Abbildungen vorgesehen sind, wobei das zu inspektierende Objekt geometrische Fehler im Vergleich zu dem Referenzobjekt aufweisen kann, dadurch gekennzeichnet, dass die Anlage aufweist:

— Mittel (37, 40, 45) zur Herstellung von elektronischen binaeren Abbildungen von dem Referenzobjekt und dem zu inspektierenden Objekt $I_{REF}$ und $I_{EXA}$;
— Mittel zur Verarbeitung (43), die Mittel zur Einstellung (48, 49) von $I_{REF}$ auf den maximalen und minimalen Toleranzen, in Abhaengigkeit von vorbestimmten Daten, durch Dehnung und Erosion eines Konstruktionselements B aufweisen, dessen Groesse bei jedem Bildpunkt, im folgenden als Pixel bezeichnet, sich veraendern kann, Vergleichsschaltungen (51A, 51B) fuer die Herstellung von Abbildungen mit Fehlern des Typs "Ausdehnung" und "Fehlen" durch Ausfuehrung der jeweiligen logischen Operationen:

$$[(I_{REF})_{max} \text{ ODER } I_{EXA}] \text{ ODER EXC } (I_{REF})_{max} \text{ und}$$

$$[(I_{REF})_{min} \text{ ODER } I_{EXA}] \text{ ODER EXC. } I_{EXA} \text{ und}$$

— Auswertungsmittel (52A, 52B) fuer die Fehler, die Mittel (80A, 80B) zur Messung der Groesse der Fehler und Mittel zum Vergleich (81A, 81B) mit Verwerfungsmitteln aufweisen, die bei jedem Pixel in Abhaengigkeit von vorbestimmten Daten bestimmen, welche Fehlerdimensionen annehmbar sind; und
— Sortierungs- und Auswahlmittel der als "richtig" erkannten Objekten.

18. Anlage gemaess Anspruch 17, dadurch gekennzeichnet, dass sie ausserdem aufweist:

— Mittel zur Synkronisierung und Adressierung (27, 47), die bei jedem geprueften Pixel die vorbestimmten Daten in einem Speicher (45) auslesen, worin sie vorher geladen wurden.

19. Anlage gemaess Anspruch 18, dadurch gekennzeichnet, dass die Erfassungsmittel (21, 24) in der Gruppe gewaehlt sind, die elektronische Mikroskope, Fernsehenkameras, Photodioden-Netzwerke und Ladungstraeger-Netzwerke einschliesst.

20. Anlage gemaess Anspruch 18 oder 19, dadurch gekennzeichnet, dass die Mittel zur Herstellung von den elektronischen Abbildungen $I_{REF}$ und $I_{EXA}$ eine Schwellwert-Funtion-Einheit (37, 40) zur Festlegung des Schwellwerts von mindestens $I_{EXA}$ aufweisen.

21. Anlage gemaess Anspruch 18 oder 19, dadurch gekennzeichnet, dass $I_{REF}$ in einem Pufferspeicher gespeichert ist.

22. Anlage gemaess Anspruch 18, 19, 20 oder 21, dadurch gekennzeichnet, dass sie ausserdem Mittel zur Berechnung (42) aufweist, die die Positionierung der elektronischen Abbildungen $I_{REF}$ und $I_{EXA}$ beibehalten und korrigieren.

23. Anlage nach einem der Ansprueche 17 bis 22, dadurch gekennzeichnet, dass die Einstellmittel eine Einstellschaltung von $I_{REF}$ auf den minimalen dimensionellen Toleranzen mittels eines kreisfoermigen Konstruktionselements mit einer veraenderlichen Groesse aufweist, das aus einer Vielzahl von konzentrischen Kraenzen (C1—C4) besteht, wobei diese Einstellschaltung auf die minimalen dimensionellen Toleranzen aufweist:

**0 054 596**

— Mittel zur Speicherung (RD1—RD18) der gesamten I-Pixel in Speicherzellen, wo diese Pixel das Konstruktionselement ausbilden;

— eine Vielzahl von UND-Gates (60, 63), die jeweils zur Ausbildung der einzelnen Kraenzen dienen, wobei die Eingaben fuer jeden UND-Gate aus dem Inhalt der Zellen besteht, die den zur Ausbildung der beitreffenden Kranze beitragenden Pixel entsprechen; und

— Dekoder (64—68) zu Auswahl der Zahl und der Reihe von den erwuenschten Kraenzen; und

— ein UND-Gate (69) zur Integrierung der ausgewaehlten Kraenzen, so dass nur das Signal $(I_{REF})_{min}$ am Ausgang dieses Gate liegt.

24. Anlage gemaess Anspruch 23, dadurch gekennzeichnet,

— dass die Speicherungsmittel einerseits n Verschiebungsregister (RD1 bis RD9), wobei die Zahl von Zellen der Zahl der in jeder Linie von $I_{REF}$, vorliegenden Pixel und n der Zahl der Linien in dem Konstruktionselement entspricht, und andererseits n Verschiebungsregister (RD10 bis RD18) aufweisen, die aus Zellen mit parallelen Ausgaengen bestehen, in den die Zahl von Zellen der Zahl von Spalten in dem Konstruktionselement entspricht.

25. Anlage gemaess Ansprueche 17 bis 24, dadurch gekennzeichnet, dass die Einstellmittel eine Schaltung zur Einstellung von $I_{REF}$ auf die maximalen dimensionellen Toleranzen mittels eines kreisfoermigen Konstruktionselements mit einer veraenderlichen Groesse aufweisen, das aus einer Vielzahl von konzentrischen Kraenzen (C1—C4) besteht, wobei diese Einstellschaltung auf die maximalen dimensionellen Toleranzen aufweist:

— Mittel (RD1—RD18) zur Speicherung von allen Pixel von $(I_{REF})^c$, die zur Ausbildung des Konstruktionselements betragen, in Speicherzellen;

— eine Vielzahl von UND-Gates (60, 63) jeweils zur Ausbildung von den einzelnen Kraenzen, wobei die Eingaben fuer jeden UND-Gate aus dem Inhalt der Zellen bestehen, die den zur Ausbildung der betreffenden Kranze beitragenden Pixel entsprechen;

— Dekoder (64—68) zum Auswahl der Zahl und der Reihe der erwuenschten Kraenze; und

— ein UND-Gate (69) zur Integrierung der ausgewaehlten Kraenze, so dass am Ausgang dieses Gate nur das Signal $(I_{REF})_{max}$ liegt, wo eine NICHT-Schaltung (71) dem Gate nachgeschaltet ist;

— eine weitere NICHT-Schaltung (70), die am Eingang der Speicherungsmittel angeordnet ist.

**Claims**

1. A process for inspecting and automatically sorting objects showing patterns with dimensional tolerances and reject criteria varying in accordance with the location of said patterns, of the type including the comparison of the image of a reference object with the image of an object to be inspected, the latter being liable to show geometrical defects with respect to the reference object, characterized in that it includes the following steps:

— Elaborating binary electronic images $I_{REF}$ and $I_{EXA}$ from the reference object and the object to be inspected,

— Defining a structuring element B for each image point (pixel), the size of said structuring element being able to vary for each pixel in function of predetermined data and adjusting $I_{REF}$ to the maximum and minimum dimensional tolerances by expanding and eroding said image by means of structuring element B, which provides $(I_{REF})_{max}$ and $(I_{REF})_{min}$,

— Forming images of the "spreading" and "lack" type defects by respectively carrying out the following logical operations:

$$[(I_{REF})_{max} \text{ OR } I_{EXA}] \text{ EXCL. OR } (I_{REF})_{max} \text{ and}$$

$$[(I_{REF})_{min} \text{ OR } I_{EXA}] \text{ EXCL. OR } I_{EXA},$$

— Measuring the size of the defects on the defect images and comparing said defects with respect to reject criteria which define, for each pixel, the dimensions of the defects which can be accepted according to predetermined data, and

— Sorting and selecting objects without any defect or showing defects allowed by the reject criteria.

2. A process as set forth in claim 1 characterized in that the step provided for elaborating images $I_{REF}$ and $I_{EXA}$ includes the following operations:

picking-up images $I_{ref}$ and $I_{exa}$ of the reference object and of the object to be inspected in analog form, in black and white, with all the grey levels,

sampling images according to a determined frame chosen in the group including for instance the hexagonal frame or the square frame,

quantizing the image to retain only a number $2^N$ of grey levels with $2 \leq N \leq 6$, and
thresholding the images to obtain said electronic binary images.

3. A process as set forth in claim 2 characterized in that the thresholding operation includes the determination of the threshold of images $I_{ref}$ and $I_{exa}$, which is carried out from the histogram of the pixel intensities.

4. A process as set forth in claim 3 characterized in that the threshold determination is program controlled.

5. A process as set forth in claim 1 characterized in that the elaboration of binary electronic images $I_{REF}$ and $I_{EXA}$ includes the following operations:

picking-up image $I_{exa}$ of the object to be inspected in analog form, in black and white, with all the grey levels,

sampling this image according to a determined frame chosen in the group including for instance the hexagonal frame or the square frame,

quantizing the image to retain only a number $2^N$ of grey levels with $2 \leq N \leq 6$,

thresholding the image to obtain $I_{EXA}$ and directly elaborating $I_{REF}$ either from a digital pattern generator or from a data bank.

6. A process as set forth in any one of the above claims characterized in that it further includes a step for suppressing noise from images $I_{REF}$ and $I_{EXA}$ carried out prior to the dimensional tolerance adjustment step and consisting either in an opening operation, or in a closing operation, or in a combination of both, the size of the erosion being lower than the size of the smallest defect to be detected.

7. A process as set forth in claim 4, 5 or 6, characterized in that it further includes a step for centering electronic images $I_{REF}$ and $I_{EXA}$, said step corresponding to the optical centering of images $I_{ref}$ and $I_{exa}$.

8. A process as set forth in any one of the above claims characterized in that the structuring element has the approximate shape of a circle with a variable diameter.

9. A process as set forth in claim 8 characterized in that the structuring element is comprised of a plurality of concentric rings which develop from the central pixel which is the pixel under analysis, these rings being separated one from the others by an interval equal to the interval separating two pixels.

10. A process as set forth in any one of the above claims, characterized in that the size of each defect is determined by computing the horizontal and vertical projections along, at least, a pair of perpendicular axes.

11. A process as set forth in claim 10, characterized in that the direction of one of the perpendicular axes corresponds to main direction $\theta$ of the pattern which contains the defect.

12. A process as set forth in claim 11 characterized in that reject criteria are deduced from the dimensions and direction of the pattern and appear as terms which can be compared with said projections.

13. A process as set forth in any one of the above claims characterized in that said predetermined data are provided in two data tables No. 1 and No. 2, respectively, for the defects of the "lack" type and of the "spreading" type.

14. A process as set forth in claim 13 characterized in that, for each pixel, the corresponding data include dimensional tolerances N, pattern direction $\theta$ and the reject criteria which define one or several analysis windows.

15. A process as set forth in claim 12 characterized in that the reject criteria, the dimensional tolerance and direction $\theta$ are common to all the pixels of a same region.

16. A process as set forth in claim 15 characterized in that the reject criteria, the dimensional tolerance and direction $\theta$ are automatically generated for each region by a computer after a scanning of $I_{REF}$ along the possible directions of the configuration patterns through the use of a program.

17. An apparatus for inspecting and automatically sorting objects showing patterns with dimensional tolerances and reject criteria varying with the location of the inspected region of the object, of the type comprising means (21, 24) for picking-up the image of a reference object (22) and the image of an object to be inspected (25) and means for comparing said images, the object to be inspected being liable to show geometrical defects with respect to the reference object, characterized in that it includes:

means (37, 40, 45) for elaborating binary electronic images $I_{REF}$ and $I_{EXA}$ of the reference object and of the object to be inspected,

processing means (43) including means (48, 49) for adjusting $I_{REF}$ by expanding and eroding it to the maximum and minimum tolerances, by using a structuring element B the size of which can vary for each pixel, in function of predetermined data, compare means (51A, 51B) for forming images of the defects of the "spreading" and "lack" types by respectively carrying out the following logic operations:

$$[(I_{REF})_{max} \text{ OR } I_{EXA} \text{ EXCL. OR } (I_{REF})_{max} \text{ and}$$

$$(I_{REF})_{min} \text{ OR } I_{EXA} \text{ EXCL. OR } (I_{EXA}), \text{ and}$$

means (52A, 52B) for analysing defects, including means (80A, 80B) for measuring the size of the defects and means (81A, 81B) for comparing said defects with reject criteria defining for each pixel, the defect dimensions which can be accepted, in accordance with predetermined data, and

means for sorting and selecting the objects which are accepted.

26

18. An apparatus as set forth in claim 17 further characterized in that it includes:

synchronizing and addressing means (27, 47) which, for each pixel which is analysed, fetch said predetermined data out of a memory (45) into which they have been previously charged.

19. An apparatus as set forth in claim 18 characterized in that picking-up means (21, 24) are chosen from the group including the electron microscopes, the TV cameras, the photodiodes arrays and the coupled charge devices.

20. An apparatus as set forth in claim 18 or 19 characterized in that said means for elaborating electronic images $I_{REF}$ and $I_{EXA}$ include a unit (37, 40) for detecting a threshold and for thresholding at least $I_{EXA}$.

21. An apparatus as set forth in claim 18 or 19 characterized in that $I_{REF}$ is stored in a buffer memory.

22. An apparatus as set forth in claim 18, 19, 20 or 21 characterized in that it further includes computing means (42) for recentering electronic images $I_{REF}$ and $I_{EXA}$.

23. An apparatus as set forth in any one of claims 17 to 22 characterized in that the adjusting means comprise a circuit for adjusting $I_{REF}$ to the minimum dimensional tolerances by using a structural element of circular shape and variable size, formed of a plurality of concentric rings (C1, C4) said circuit for adjusting $I_{REF}$ to the minimum dimensional tolerances comprising:

means (RD1—RD18) for storing all the pixels of $I_{REF}$ constituting said structuring element, into memory cells,

a plurality of AND gates (60—63) respectively forming each of said rings, the inputs of each AND gate being constituted by the contents of the cells corresponding to the constitutive pixels of the ring under consideration,

decoding means (64, 68) for selecting the number and rank of the rings to be considered, and

an AND gate (69) for integrating said selected rings so that signal $(I_{REF})_{min}$ is obtained at the output of said gate.

24. An apparatus as set forth in claim 23, characterized in that:

said storing means include on the one hand, n shift registers (RD1—RD9), the cell number of which corresponds to the pixel number of each line of $I_{REF}$, and n corresponds to the line number of the structuring element, and on the other hand, n shift registers (RD10—RD18) comprised of cells with parallel outputs, the cell number of which corresponds to the number of columns of the structuring element.

25. An apparatus as set forth in any one of claims 17—24, characterized in that the adjusting means comprise a circuit for adjusting signal $I_{REF}$ to the maximum dimensional tolerances by using a structuring element of circular shape and variable size, comprised of a plurality of concentric rings (C1—C4), said circuit for adjusting $I_{REF}$ to the maximum dimensional tolerances including:

means (RD1—RD18) for storing all the pixels of $(I_{REF})^c$ constituting said structuring element into memory cells,

a plurality of AND gates (60—63) respectively constituting each of said rings, the inputs of each AND gate consisting in the contents of the cells corresponding to the constitutive pixels of the ring under consideration,

decoding means (64—68) for selecting the number and rank of the rings to be considered, and

an AND gate (69) followed by an invert circuit (71) for integrating said selected rings so that signal $(I_{REF})_{max}$ is obtained at the output of this gate,

a second invert circuit (70) provided at the input of the memory means.

# FIG. 1A

# FIG. 1B

250μ    125μ    100μ

FIG. 2

IMAGES DES DEFAUTS

M

FENETRE D'ANALYSE

BLOC D'ANALYSE DES DEFAUTS

COMPARAISON

$I_{REF}\,max$ $I_{REF}\,min$

$I_{REF}$

BLOC D'AJUS-TEMENT AUX TOLERANCES DIMENSIONNELLES

$I_{REF}$

$I_{EXA}$

MEMOIRE

TOLERANCES DIMENSIONNELLES

CRITERES DE REJET

CIRCUIT DE SYNCHRONISATION ET D'ADRESSAGE

$I_{ref}$

$I_{exa}$

$I_{VIRT}$

FIG.3

0 054 596

# FIG. 4

NOMBRE DE
POINTS IMAGES

500 000

400 000

300 000

200 000

100 000

IMAGE DONT LE FOND
PRESENTE UN GRADIENT
DE GRIS

PIC N°2

IMAGE BIEN
CONTRASTÉE

PIC N°1

0  1  2  3  4  5  6  7  8  9  10  11  12  13  14  15

$N_{TH1}$

NIVEAUX DE GRIS

$I_{M_X}$

$Y_1$

$Y_1 + P$

MOTIF $I_{EXA}$

MOTIF $I_{REF}$

$M_X$

# FIG.6

4

# FIG.5

IMAGE ERODEE

IMAGE INITIALE

ELEMENT STRUCTURANT

# FIG.13

TRAVERSEES HORIZONTALES

TRAVERSEES VERTICALES

DIAGONALES 45°

DIAGONALES 135°

# FIG.7

# FIG.8

# FIG.9

A  B  C

# FIG.10

A  B  C  D

# FIG. 11A

# FIG. 11B

FIG. 12

FIG.14

0 054 596

# FIG.15

$I_{REF}$   $I_{EXA}$

43

44

| BLOC AJUSTEMENT AUX TOLERANCES —EROSION— | BLOC AJUSTEMENT AUX TOLERANCES —DILATATION— |

48

49

$I_{REFMIN}$

55

ら   50

56

$I_{REFMAX}$

2   1

2   1

| COMPARAISON | COMPTEUR    47 | COMPARAISON    51B |

51A'

| MEMOIRE |
| TABLE N°1 | TABLE N°2    45 |
| TOLERAN- CES | TOLERAN- CES |
| CRITERES DE REJET | CRITERES DE REJET |

IMAGE DES DEFAUTS —MANQUES—

IMAGE DES DEFAUTS —EXTENSIONS—

75A

75B

57

58

| BLOC D'ANALYSE DES DEFAUTS | BLOC D'ANALYSE DES DEFAUTS |

52A

52B

53A

53B

OU    54

46

VERS CALCULATEUR 28

11

# FIG. 16

# FIG. 19

FIG.17

FIG.18

# FIG. 20

# FIG. 21

| TABLE N°1 | | | | |
|---|---|---|---|---|
| N = 25 $\mu$ | $\Theta$ = 0° | $\underset{min}{75 \mu}$ $L \quad -A$ | $\underset{min}{25 \mu}$ $X\% L$ | $\underset{min}{175 \mu}$ $K.L$ |

15

FIG.22

FIG.23

0 054 596

FIG. 24

18

0 054 596